# EUROPÄISCHE PATENTSCHRIFT

(11) **EP 2 632 867 B1**
(45) Veröffentlichungstag und Bekanntmachung des Hinweises auf die Patenterteilung: **14.10.2015**
(21) Anmeldenummer: 11779603.7
(22) Anmeldetag: 25.10.2011
(51) Int. Cl.: C03C 3/062, C03C 3/064, C03C 3/068, C03C 3/078, C03C 3/083, C03C 3/089, C03C 3/091, C03C 3/093, C03C 3/095, C03C 17/42, H01L 51/50

(54) **TRANSPARENTE SCHICHTVERBUNDE**
TRANSPARENT LAYER COMPOSITE ASSEMBLIES
STRUCTURES COMPOSITES EN COUCHES TRANSPARENTES

(30) Priorität: 26.10.2010 DE 102010042945
(43) Veröffentlichungstag der Anmeldung: 04.09.2013
(73) Patentinhaber: SCHOTT AG, 55122 Mainz (DE)
(72) Erfinder: WOLFF, Silke, 42499 Hückeswagen (DE); WÖLFEL, Ute, 55130 Mainz (DE); RITTER, Simone, 55131 Mainz (DE); BRIX, Peter, 55116 Mainz (DE)
(74) Vertreter: Fuchs Patentanwälte Partnerschaft mbB
(86) Internationale Anmeldenummer: PCT/EP2011/068637
(87) Internationale Veröffentlichungsnummer: WO 2012/055860

(56) Entgegenhaltungen:
- EP-A1- 2 452 926
- WO-A1-2005/085147
- WO-A1-2009/154314
- WO-A2-2010/138698
- WO-A2-2010/138784
- DE-A1-102006 062 092
- DE-A1-102010 023 619
- DE-B3-102013 102 848
- DE-C1- 10 005 088
- DE-T5-112012 002 137
- FR-A1- 2 937 798
- JP-A- 11 135 819
- US-A- 6 163 110
- US-A1- 2006 043 402
- US-A1- 2008 149 863
- ROSENOW THOMAS ET AL: "Highly efficient white organic light-emitting diodes based on fluorescent blue emitters", JOURNAL OF APPLIED PHYSICS, AMERICAN INSTITUTE OF PHYSICS. NEW YORK, US, Bd. 108, Nr. 11, 9. Dezember 2010 (2010-12-09), Seiten 113113-113113, XP012142014, ISSN: 0021-8979, DOI: 10.1063/1.3516481
- SAXENA K ET AL: "A review on the light extraction techniques in organic electroluminescent devices", OPTICAL MATERIALS, ELSEVIER SCIENCE PUBLISHERS B.V. AMSTERDAM, NL, Bd. 32, Nr. 1, 1. November 2009 (2009-11-01), Seiten 221-233, XP026698742, ISSN: 0925-3467, DOI: 10.1016/J.OPTMAT.2009.07.014 [gefunden am 2009-08-27]
- YOKOYAMA D ET AL: "Horizontal orientation of linear-shaped organic molecules having bulky substituents in neat and doped vacuum-deposited amorphous films", ORGANIC ELECTRONICS, ELSEVIER, AMSTERDAM, NL, Bd. 10, Nr. 1, 1. Februar 2009 (2009-02-01), Seiten 127-137, XP025845814, ISSN: 1566-1199, DOI: 10.1016/J.ORGEL.2008.10.010 [gefunden am 2008-10-22]
- Datenblätter: "Optisches Glas", , 25 April 2013 (2013-04-25), XP055176798, Retrieved from the Internet: URL:http://www.schott.com/advanced_optics/ german/abbe_datasheets/schott_datasheet_al l_german.pdf [retrieved on 2015-03-16]
- "Optical Glass Data Sheets Inquiry Glass", , 25 April 2013 (2013-04-25), XP055177005, Retrieved from the Internet: URL:http://www.schott.com/advanced_optics/ english/abbe_datasheets/schott_datasheetin quiryglass_all_english.pdf [retrieved on 2015-03-16]
- LU M-H ET AL: "External coupling efficiency in planar organic light-emitting devices", APPLIED PHYSICS LETTERS, AMERICAN INSTITUTE OF PHYSICS, US, vol. 78, no. 13, 26 March 2001 (2001-03-26), pages 1927-1929, XP012027641, ISSN: 0003-6951, DOI: 10.1063/1.1357207

## Beschreibung

Die vorliegende Erfindung betrifft transparente Schichtverbunde, die zur Verwendung in Leuchtdioden, vorzugsweise mit organischen Halbleitern (OLEDs), geeignet sind und ein Verfahren zur Herstellung solcher Schichtverbunde.

Basierend auf der Entdeckung der Halbleiter zu Beginn des 20. Jahrhunderts und deren systematischer Weiterentwicklung revolutionierte die Entwicklung der klassischen anorganischen Leuchtelektrode (LED) Mitte des 20. Jahrhunderts den Sektor Beleuchtung des Applikationsbereichs Optik/Optoelektronik. Eigenschaften wie z.B. extrem lange Lebensdauer, hohe Modulationsgeschwindigkeit, hohe Wirkungsgrade und mechanische Unempfindlichkeit im Vergleich zu Standard-Hohlleuchtkörpern ergänzen die Vorteile dieser nahezu monochromen Kaltlichtquellen, die inzwischen in vielen Wellenlängenabstufungen verfügbar sind.

Ein Nachteil dieser klassischen LEDs, der besonders im Sektor Display und Flächenbeleuchtung zum Tragen kommt, ist die anorganische Natur des Halbleiters. Um Flächen ausleuchten zu können, bzw. einen Flächenleuchtkörper zu erhalten, müsste das anorganische Material eben in dünnen, breitflächigen Schichten zur Verfügung gestellt werden, was aufgrund prozesstechnischer Komplexität wirtschaftliche Probleme bereitet.

Hier zeigt sich der große Vorteil einer neueren Generation LEDs, der organischen Leuchtdioden (OLEDs). Hier wird ein organischer Halbleiter (Emitterschicht) flexibel und wirtschaftlich auf eine transparente, leitfähige Oxidschicht, häufig aus Indiumzinnoxid (ITO) gedruckt (Anode), ggf. mit einer Schutzschicht gegen Sauerstoff und Wasser geschützt und mit einer weiteren leitfähigen, metallischen oder legierten Schicht (Kathode) versehen. Dieser Schichtverbund bildet die OLED.

Die transparente, leitfähige Oxidschicht (z.B. ITO) oder eine andere hochleitfähige und transparente Schicht (z.B. Graphen) wird dafür zunächst auf ein Substratmaterial aufgebracht, das von seiner thermischen Belastbarkeit her den Anforderungen des ITO-Prozesses angepasst sein muss. Bei diesem Substrat handelt es sich sogar um ein Superstrat, da die in der Emitterschicht erzeugte Strahlung über diese Schicht ausgekoppelt wird.

In der Regel wird daher Dünnglas als Substrat eingesetzt, das zwar nicht die mechanische Flexibilität einer Kunststoffschicht mit sich bringt, dafür aber bessere chemische Resistenz aufweist und den thermischen Ansprüchen besser gewachsen ist und somit insgesamt stabilere und langlebigere Schichtverbunde erzeugt.

Nun wird bei OLEDs in der Regel etwa nur 20 bis 25% des in der Emitterschicht erzeugten Lichtes durch das Superstrat emittiert. Ein großer Teil des erzeugten Lichtes verbleibt in geführten optischen Moden innerhalb der organischen Schichten oder dem Substrat. Ein Teil dieses Lichtverlustes ist auf Totalreflektionen an den Grenzflächen Luft/Superstrat/Anode zurückzuführen.

Besonders die Totalreflektion an der Grenzschicht Superstrat/Anode ist auf den Unterschied in den spezifischen Brechungsindizes der beiden Materialien zurückzuführen. Üblicherweise wird Kalknatronglas mit einem Brechwert von n_{d} = 1,53 als Superstrat verwendet, eine ITO-Schicht jedoch zeigt einen Brechungsindex von n_{d} = 2,1. Unter diesen Voraussetzungen ist die Totalreflexion beträchtlich. Die Verwendung eines höher-brechenden, also möglichst in der Brechung an das Anodenmaterial angepassten, Glases als Superstratmaterial würde somit das Maß der Totalreflektion deutlich verringern und somit die Effizienz der Lichtauskopplung aus dem Schichtverbund deutlich erhöhen. Somit würde die Effizienz der OLEDs auf diese Weise sowohl in Bezug auf die reine Lichtausbeute (Helligkeit/Kontrast), aber auch in Bezug auf verringerte Wärmelast eines möglichen Endprodukts, z.B. eines OLED-Displays optimiert.

Gläser mit Brechungsindizes im Bereich oberhalb n_{d} = 1,5 bis hin zu 1,7 sind durchaus bekannt. Im Bereich der technischen Gläser werden diese jedoch durch hohe Zusätze des ökologisch bedenklichen und auch für wirtschaftliche Groß-Prozesse schädlichen Bleioxids erreicht. Bekannte klassisch-optische Gläser mit optischen Lagen im erhöhten Brechwertbereich, die für Licht- und Bildleitung eingesetzt werden und damit die klassischen Applikationsfelder bedienen (u.a. Abbildung, Mikroskopie, Medizintechnik, Digitale Projektion, Photolithographie, Optische Nachrichtentechnik, Optik/Beleuchtung im Sektor Automotive), werden in der Regel aufgrund der Geometrie ihrer nachfolgend produzierten Erzeugnisse (Linsen, Prismen, Fasern, u.a.) als Bulkmaterial gefertigt. So sind Barrenabschnitte kontinuierlicher Barrenfertigung, Faserkemglasstäbe sowie optische Blöcke Standardformate des Fertigungsprozesses optischer Gläser. Als wirtschaftlich und applikativ sinnvolle Mindestabmessung in Richtung der kleinsten geometrischen Ausdehnung, üblicherweise die Dicke (Barrenabschnitte) oder der Durchmesser (Faserkernglasstäbe) werden 20 mm angesehen, erwünscht sind Dicken ab 40mm und optische Blöcke beginnen erst bei etwa 150mm.

Und doch muß die Auswahl der hochbrechenden Substratgläser trotz der oben dargestellten Vorteile eines möglichst hohen Brechwerts, in Bezug auf eine weitere optische Eigenschaft eingeschränkt werden.

Naturgemäß ist (optischen) Gläsern die Wellenlängenabhängigkeit des Brechwertes eigen. Diese "Dispersion" genannte Eigenschaft führt dazu, daß beim Durchstrahlen eines Körpers aus optischem Material, mit einem von 1 verschiedenen Brechwert, mit nichtmonochromatischer Strahlung (in den Bereichen Beleuchtung und Display hautpsächlich Licht des UV-vis-Bereichs des elektro-magnetischen Spektrums; 250 - 850nm), diese Strahlung in ihre spektralen Bestandteile aufgespalten (dispergiert) wird. Kurz: beim Durchgang durch das Material werden Strahlen kürzerer Wellenlängen stärker gebrochen, als solche höherer Wellenlängen. So allgemein bekannt durch den Prismeneffekt an Glas- oder Kunststoffprismen oder auch den Regenbogen-Effekt an Wasser. Dabei gilt grob die Korrelation: je höher der Brechwert des Materials (beispielsweise bei fixer Wellenlänge/Spektrallinie d = 587,6 nm), desto höher im Allgemeinen auch die Dispersion auf dieser optischen Linie.

Im Bereich der optischen Gläser wird der Brechwert mit n, die Dispersion mit v bezeichnet, die betrachteten Spektrallinien werden dabei entweder durch Wellenlängenangabe oder definierte Buchstaben-Kodierung indexiert (nₓ und vₓ; x: betrachtete Wellenlänge). Hierbei handelt es sich nicht um eine lineare Korrelation, sondern, in Abhängigkeit von den Materialklassen, - familien und -typen, um eine zusätzlich durch die Eigenschaften Teildispersion Px;y (x,y bezeichnen dabei die jeweils betrachteten Grenzwellenlängen des relevanten Bereichs) und anomale relative Teildispersion ΔPx;y gekennzeichnete Beziehung. Somit wird also die Dispersion vₓ nicht eindeutig durch den Brechwert nₓ vorgegeben, wenn auch der Zusammenhang in dieser Diskussion ausreichend belastbar gegeben ist, ohne Teildispersion und anomale relative Teildispersion berücksichtigen zu müssen.

Für die Bereiche Display (=Propargation von Licht durch eine abschattende Matrix/Maske) und Beleuchtung (homogene Ausleuchtung einer definierten Fläche), die beide einen signifikanten Arbeitsabstand zwischen Projektionsfläche/Betrachter und Lichtquelle aufweisen, bedeutet die Dispersion des Lichts in der Nähe der Lichtquelle bereits bei einer punktförmigen Lichtquelle ein Problem, sobald nicht mehr ausschließlich Licht einer definierten Wellenlänge eingesetzt wird, sondern nicht-monochromatisches Licht aus einer einzelnen Beleuchtungszelle oder jeweils monochromatisches Licht aus eng nebeneinander auf dem gleichen Substrat/Superstrat angeordneten different-farbigen Beleuchtungszellen. Die kurzwelligen Bestandteile des Lichts werden stärker gebrochen, als die langwelligeren und somit in Abbildungsentfernung, bzw. der Bildebene, wellenlängenabhängig unterschiedlich große Teil-Farbbilder dargestellt werden: die Abbildung, sei es nun im Sektor Beleuchtung ein Lichtfleck oder im Sektor Display eine definierte Form, zeigt regenbogenartig anmutende Farbsäume an ihren natürlichen Strukturen. Dabei hängt die Stärke der applikativen Beeinträchtigung von der sensorischen Akzeptanz ab. In hoch-qualitativen klassisch-optischen Systemen, wie beispielsweise Kamera-Objektivsystemen oder Projektoren, werden zur sogenannten Farbkorrektur äußerst aufwändige optische Designs mit einer systemisch kombinierten Vielzahl von Einzellinsen aus differierenden optischen Gläsern eingesetzt. Da sich dies bei einem Superstrat, wie dem erfindungsgemäßen, aus seiner Anwendung heraus verbietet, kann hier keine Korrektur von potentiell auftretenden Farbfehlern erfolgen, falls die Dispersion im Superstratmaterial zu hoch ist.

Verstärkend kommt die angestrebte flächige Natur von OLEDs als Lichtquelle zum Tragen. In den flächigen Mittenbereichen überlagern sich die different-chromatischen Teilbilder der virtuellen Punktlichtquellen, so daß zumindest im Bereich Display Bildschärfe verloren geht, wenn auch durch Überlagerung der spektralen Anteile scheinbar kein farbfalscher Eindruck entsteht. In beiden Applikationsbereichen treten zudem an den Rändern die beschrieben Farbsäume auf.

Es läßt sich jedoch kein allgemeingültiger, optimaler Dispersionsgrenzwert angeben, da die applikativ maximal-akzeptierbare Dispersion in diesen Sektoren stark vom Systemdesign und der angestrebten Applikation, also der sensorischen Wahrnehmung und Toleranz des Fehlers abhängt. Eine Auswahl kann dennoch durch Einhaltung von sicher geeigneten Werten erfolgen.

Damit ergibt sich ein weiteres Auswahlkriterium für die hochbrechenden opto-technischen Hybridgläser. Sie müssen eine möglichst geringe Dispersion aufweisen. Da diese Bedingung in einem technischen trade-off zu der Bedingung möglichst hohen Brechwerts steht und zudem ein applikatives k.o.-Kriterium darstellt, wird so automatisch die Zusatzbedingung eines nicht zu hohen Brechwerts obligat. Aufgrund der Nicht-Eindeutigkeit der Brechwert-Dispersions-Korrelation (s.o.) in optischem Glas und somit auch in den opto-technischen Hybridgläsern, ergeben sich folgende Einschränkungen. Gläser mit Brechwerten von nd < 1,8 zeigen von Natur aus ausreichend geringe Dispersionen (Abbezahlen v_{d} zwischen 23 - >>70) (die Abbezahl wird kleiner, wenn die Dispersion steigt; umgekehrt-proportionale Darstellung der Dispersion). Gläser mit Brechwerten von n_{d} ≥ 1,8 jedoch können Dispersionen bis in Abbezahlbereiche von v_{d} < 15 erreichen. Hier muß auf Gläser mit geringeren Dispersionen zurück gegriffen werden. Damit verbieten sich bekannte optische Glassysteme in der Auswahl, die durchaus Brechwertbereiche von nd > 2,0 erreichen, aber gleichzeitig Dispersionen bis zu v_{d} < 15 aufweisen.

Auch neuere Produktionsweisen, wie beispielsweise die wirtschaftlichere in situ Komponentenfertigung durch endgeometrienahe Präzisionsheißformgebungsverfahren (PHFG) zählen, zumindest im Gegensatz zu den Flachglasverfahren mit üblichen wenigen Millimetern Produktdicke, noch zu den Bulkglasverfahren. Durch den Bulkproduktionsprozeß sind diese Materialien spezifischen Rahmenbedingungen unterworfen, deren prominenteste die erforderliche Einstellung eines Temperatur-Viskositätsverhaltens in den Gläsern darstellt, dass in der Glasmachersprache mit "Kürze des Glases" benannt wird. Dies bedeutet, dass die Viskosität stark mit der sich verändernden Temperatur variiert. So werden kurze Formschlusszeiten in der PHFG genauso erreicht wie zügige Formstabilität, geringe Einschmelztemperaturen und schnelle Kühlvorgänge, ohne entweder Ausschuss durch Spannungsbruch oder unwirtschaftlich lange Prozesszeiten (Schmelzprozess & Kühlung) befürchten zu müssen.

In genau diesen Eigenschaften unterscheiden sich die klassisch-optischen Gläser von den technischen Standardgläsern, deren physiko-chemische Eigenschaftsprofile speziell auf die technischen Rahmenbedingungen der im Vergleich zu den Fertigungsaggregaten optischer Gläser signifikant größeren Fertigungsaggregaten technischer Gläser, eben Flach-, Dünn- und Rohrgläser, zugeschnitten sind.

Technische Gläser besitzen üblicherweise ein "langes" Viskositätsprofil, das heißt, ihre Viskosität variiert nicht so stark mit differierender Temperatur. Hieraus resultieren längere Zeiten der jeweiligen Einzelprozesse, sowie insgesamt erhöhte Prozesstemperaturen, was sich bei den technischen Großaggregaten weniger ausgeprägt negativ auf die Wirtschaftlichkeit auswirkt. Hinzu kommen signifikant erhöhte Verweilzeiten der Materialien in den Aggregaten, aufgrund von Strömungsbedingungen und Aggregatgröße. Lange Gläser sind kontinuierlichen Großaggregaten vorteilhaft, weil diese Gläser eine größere Temperaturspanne aufweisen, in der sie verarbeitet werden können. Das Verfahren muss also nicht auf eine möglichst schnelle Verarbeitung des noch heißen Glases ausgerichtet sein.

Wollte man nun klassisch-optische Materialien in einem technischen Standard-Flachglasprozess (z.B. ziehen, overflow fusion, down draw, walzen, o.a.) produzieren, würden die erforderlichen Änderungen in den Eigenschaftsprofilen chemisch genau auf die Variation bzw. Reduzierung derjenigen Komponenten abzielen, die den optischen Gläsern ihre außergewöhnlichen Eigenschaften verleihen: Reduzierung von beispielsweise TiO₂, ZrO₂ oder La₂O₃ führte zwar zu längeren und weniger kristallisationsempfindlichen Gläsern, aber auch zu einem deutlichen Verlust an Brechwert- und Dispersionseigenschaften.

Erschwerend kommt hinzu, dass der aktuell aus wirtschaftlichen Gründen favorisierte Flach-/Dünnglasprozess, der Floatprozess auf flüssigem Zinnbad, bestimmte chemische Anforderungen an "floatbare" Gläser stellt, die von den klassisch-optischen Gläsern nicht eingehalten werden: es dürften neben, in Bezug auf sekundäre Kristallisation negativ wirkendem, Zinkoxid keine redoxaktiven, also keine polyvalenten Komponenten im Glas vorhanden sein. Somit verbieten sich beispielsweise optische Standardkomponenten, wie die Oxide von Blei, Phosphor, Bismuth, Niob, Wolfram sowie die klassischen polyvalenten Läutermittel, deren effektive Wirkung eben genau auf der mehrphasigen Verschiebung des Redox-Gleichgewichtes beruht. Insgesamt unterscheiden sich damit diese beiden klassischen Materialgruppen, die optischen und die technischen Gläser im Hinblick auf ihre Prozessierbarkeit in unvereinbarer Art und Weise.

Es ist daher die Aufgabe dieser Erfindung, transparente Schichtverbunde bereitzustellen, welche es ermöglichen, die in diesem Schichtverbund erzeugte Strahlung mit geringsten Verlusten auszukoppeln.

Dies wurde erfindungsgemäß durch die Schaffung einer neuen Materialklasse ermöglicht, die im Sinne eines opto-technischen Hybridmaterials die jeweils vorteilhaften Eigenschaften beider klassischen Materialgruppen in sich vereint. Diese opto-technischen Hybridgläser weisen die vorteilhaften optischen Eigenschaften Homogenität, Brechkraft und Transmission und gleichzeitig die Flachglas-prozesstauglichen Heißformgebungs-Eigenschaften Redoxstabilität, Kristallisationsstabilität und relative Länge auf. Da der Fokus im Flachglasprozess stark auf dem Floatglasprozess liegt, nimmt hier die Redoxstabilität eine herausragende Bedeutung ein.

Die Aufgabe wird durch die Gegenstände der Patentansprüche gelöst.

Die erfindungsgemäße Aufgabe wird insbesondere durch einen transparenten Schichtverbund gelöst, umfassend eine Halbleiterschicht, eine leitfähige transparente Oxidschicht und eine Substratschicht, wobei die Substratschicht ein opto-technisches Hybridglas umfasst, das einen Brechungsindex n_{d} von >1,6 aufweist.

In bevorzugten Ausführungsformen wird der Schichtverbund in einer OLED verwendet dabei umfasst die OLED zusätzlich zum Schichtverbund eine Kathode, vorzugsweise Kathodenschicht.

In alternativen Ausführungsformen können die erfindungsgemäßen Schichtverbunde auch in Solarmodulen oder als Solarmodule zum Einsatz kommen. Es liegt auf der Hand, dass mit Hilfe der erfindungsgemäß verwendeten Gläser auch für Solarmodule vorteilhafte Eigenschaften im Schichtverbund erzielt werden können, weil es auch dort auf den ungehinderten Durchgang von Licht durch ein Substratglas ankommt. Folglich können unter Verwendung der Schichtverbunde Solarmodule mit verbessertem Wirkungsgrad erhalten werden. Auch in solchen Solarmodulen wird der Schichtverbund zusammen mit einer Kathode eingesetzt.

Bevorzugte Ausführungsformen von OLEDs mit den erfindungsgemäßen Schichtverbunden weisen den folgenden Aufbau in der hier angegebenen Reihenfolge auf:
1. Substratschicht
2. transparente, leitfähige Oxidschicht (=Anode)
3. optional Schicht aus PEDOT/PSS
4. optional Lochleitungsschicht (HTL, hole transport layer)
5. Halbleiterschicht
6. optional Elektronenleitungsschicht (ETL, electron transport layer)
7. optional Schutzschicht
8. Kathodenschicht

Dabei meint PEDOT/PSS Poly(3,4-ethylendioxythiophen)/Polystyrolsulfonat; diese Schicht dient zur Absenkung der Injektionsbarriere für Löcher und Verhinderung der Diffusion von Bestandteilen der Oxidschicht in den Übergang. Die optionale Schutzschicht umfasst vorzugsweise Lithiumfluorid, Cäsiumfluorid oder Silber sowie Kombinationen davon.

Das opto-technische Hybridglas ist vorzugsweise über einen Flachglasprozess herstellbar. Unter Flachglasprozess wird erfindungsgemäß ein Prozess verstanden, der Zugang zu Glas in dem im Weiteren beschriebenen Aspektverhältnis (Dicke zu Flächenausdehnung) von Scheiben gewährt. Diese Scheiben zeichnen sich durch minimale Dicken von 0,5 mm (Dünnstgläser) über Standarddicken von 1 bis3 mm, bis hin zu Dicken von 8 mm aus. Dabei werden in kontinuierlicher Prozessführung mit Durchsätzen von üblicherweise deutlich über 100 Tagestonnen Glasbänder von bis zu 10 m (z.B. Fensterglas), üblicherweise jedoch zwischen 0,3 bis 3 m liegenden Breiten erzeugt. Die Art des Heißformgebungsprozesses variiert mit dem angestrebten Aspektverhältnis zwischen Walzen, Ziehen und Floaten, sowie DownDraw- und OverflowFusion- und verwandten Prozessen. Dadurch wird erfindungsgemäß die erforderliche Dicke der Substratschicht erreicht. Mit üblichen optischen Gläser, die einen Brechungsindex von >1,6 aufweisen, können diese Flachglasprozesse nicht durchgeführt werden, weil sie Komponenten enthalten, welche die entsprechenden Bedingungen in Flachglasprozessen nicht unverändert überstehen.

Die Substratschicht im Schichtverbund weist vorzugsweise eine Schichtdicke von weniger als 5 mm auf. Weiter bevorzugt beträgt diese Schichtdicke weniger als 3 mm und besonders bevorzugt weniger als 1 mm. Die Schichtdicke der Substratschicht darf nicht zu groß sein, weil andernfalls die Elastizität des Glases zu gering wäre. Außerdem nimmt die Transmission mit steigender Schichdicke ab. Der Schichtverbund würde insgesamt weniger elastisch. Wird die Schichtdicke aber zu klein gewählt, erschwert sich zum einen die Verarbeitbarkeit, zum anderen wird der Schichtverbund insgesamt weniger resistent gegen Beschädigung. Daher beträgt die Schichtdicke der Substratschicht vorzugsweise wenigstens 0,1 mm und weiter bevorzugt wenigstens 0,3 mm.

Es ist erfindungsgemäß, ein opto-technisches Hybridglas einzusetzen, das eine besonders vorteilhafte Elastizität aufweist. Daher weist das opto-technische Hybridglas einen Elastizitätsmodul (E-Modul) von höchstens 120*10³ N/mm², bevorzugt höchstens 105*10³ N/mm² und besonders bevorzugt höchstens 97*10³ N/mm². Wird ein Glas mit zu hohem E-Modul eingesetzt, können die Vorteile des Schichtverbundes insbesondere bei Einsatz als oder in einer OLED nicht voll ausgeschöpft werden. Trotzdem soll die Substratschicht dem Schichtverbund eine gewisse strukturelle Integrität verleihen, so dass der E-Modul vorzugsweise einen Wert von 60*10³ N/mm², weiter bevorzugt 70*10³ N/mm² und besonders bevorzugt 82*10³ N/mm² nicht unterschreiten sollte.

Die vorteilhafte Elastizität wird durch geeignete Auswahl der Inhaltsstoffe des opto-technischen Hybridglases erzielt. Dabei sollten insbesondere die Netzwerkbildner in den Gläsern hinsichtlich der Elastizität optimiert werden. Netzwerkbildner sind insbesondere SiO₂, B₂O₃, Al₂O₃.

Die opto-technischen Hybridgläser dieser Erfindung umfassen vorzugsweise SiO₂ in Mengen von wenigstens 0,5 Gew.-%, weiter bevorzugt wenigstens 3 Gew.-% und besonders bevorzugt wenigstens 10 Gew.-%. Besondere Ausführungsformen enthalten SiO₂ sogar in Mengen von wenigstens 27,5 Gew.-%. Zwar verringert SiO₂ die Elastizität der Gläser, gleichzeitig erhöht es aber deren chemische Resistenz. Um die Elastizität nicht zu stark zu beeinträchtigen, sollte der Gehalt an SiO₂ einen Wert von 71 Gew.-% vorzugsweise nicht überschreiten. Weiter bevorzugt soll der Gehalt an SiO₂ einen Wert von 55 Gew.-% und ganz besonders bevorzugt von 45 Gew.-% nicht übersteigen.

B₂O₃ verringert die Elastizität der Gläser und ist auch unter dem Gesichtspunkt der Arbeitssicherheit bei der Schmelze in nicht zu hohen Konzetrationen einzusetzen. Der Gehalt an B₂O₃ in den opto-technischen Hybridgläsern sollte daher einen Wert von 50 Gew.-% nicht übersteigen. Bevorzugte Gläser enthalten sogar nur bis zu 35 Gew.-% B₂O₃. Besonders bevorzugte Gläser enthalten B₂O₃ in Mengen von höchstens 25 Gew.-%, weiter bevorzugt höchstens 15 Gew.-% und ganz besonders bevorzugt höchstens 10 Gew.-%. Allerdings verbessert B₂O₃ die chemische Resistenz der opto-technischen Hybridgläser, so dass bevorzugte Gläser wenigstens 1 Gew.-%, weiter bevorzugt wenigstens 5 Gew.-% und besonders bevorzugt wenigstens 7 Gew.-% B₂O₃ umfassen.

Al₂O₃ verringert die Elastizität der opto-technischen Hybridgläser sehr stark. Daher sind die Gläser vorzugsweise frei von dieser Komponente. Um die chemische Resistenz der Gläser zu erhöhen, wird Al₂O₃ allerdings in bestimmten Ausführungsformen in Mengen von wenigstens 1 Gew.-% eingesetzt. Der Gehalt sollte aber vorzugsweise 10 Gew.-%, weiter bevorzugt 7 Gew.-% und besonders bevorzugt 5 Gew.-% nicht übersteigen.

Um die Elastizität der Gläser besonders günstig zu beeinflussen, enthalten die opto-technischen Hybridgläser vorzugsweise wenigstens einen Vertreter aus der Gruppe La₂O₃, Nb₂O₅, TiO₂ und BaO. Diese Komponenten haben härtende und versteifende Wirkung auf die Gläser, so dass sie den Elastizitätsmodul erhöhen. Daher sind diese Komponenten vorzugsweise in Mengen von wenigstens 7 Gew.-%, weiter bevorzugt wenigstens 15 Gew.-% und besonders bevorzugt wenigstens 25 Gew.-% in den Gläsern dieser Erfindung enthalten. Um die Elastizität nicht zu sehr zu verringern, sollte der Gehalt dieser Komponenten bevorzugt einen Betrag von 65 Gew.-%, weiter bevorzugt 55 Gew.-% und besonders bevorzugt 45 Gew.-% nicht übersteigen. Außerdem sollten diese Komponenten nicht im Übermaß eingesetzt werden, weil sie die Kristallisationsneigung des Glases erhöhen.

Aus denselben Gründen ist in bevorzugten Ausführungsformen der Gehalt an BaO im erfindungsgemäßen Glas auf höchstens 15 Gew.-% beschränkt.

Bevorzugte opto-technische Hybridgläser enthalten K₂O in Mengen von wenigstens 3,5 Gew.-%, besonders bevorzugt wenigstens 5 Gew.-%. Der Gehalt an dieser Komponente sollte vorzugsweise einen Wert von 10 Gew.-% nicht überschreiten.

Die opto-technischen Hybridgläser enthalten einen oder mehrere aus der genannten Gruppe in einem Anteil von wenigstens 15 Gew.-%, weiter bevorzugt wenigstens 30 Gew.-% und besonders bevorzugt 45 Gew.-%. Besonders bevorzugte Gläser enthalten wenigstens zwei Vertreter aus dieser Gruppe. Die Gläser sollten allerdings vorzugsweise nicht mehr als 65 Gew.-%, weiter bevorzugt nicht mehr als 60 Gew.-% und besonders bevorzugt nicht mehr als 50 Gew.-% dieser Komponenten enthalten.

Erfindungsgemäß können sogar opto-technische Hybridgläser hergestellt werden, die einen Brechwert von n_{d} ≥ 1,7 und bevorzugt n_{d} ≥ 1,8 aufweisen. Damit wird der Brechwertunterschied zwischen der transparenten Oxidschicht und der Substratschicht weiter verringert. Durch die Anhebung des Brechwertes des Substrates vergößert sich naturgemäß der Brechwertunterschied zwischen Glas und Umgebungsluft. Den dadurch entstehenden Nachteilen kann durch Aufbringen einer optionalen Antireflexschicht Rechnung getragen werden. Dem Fachmann sind solche Antireflexcoatings grundsätzlich bekannt. In Anbetracht des üblicherweise sehr hohen Brechwertes der transparenten Oxidschicht, sollte der Brechwert des opto-technischen Hybridglases einen Wert von vorzugsweise n_{d} = 2,4, weiter bevorzugt n_{d} = 2,2 und besonders bevorzugt n_{d} = 2,11 nicht übersteigen.

Aus den oben beschriebenen Gründen sollten erfindungsgemäß bevorzugt opto-technische Hybridgläser verwendet werden, die keine zu hohen Dispersionen zeigen. Daher beträgt die Abbezahl der opto-technischen Hybridgläser vorzugsweise v_{d} ≥ 15, weiter bevorzugt v_{d} ≥ 18, mehr bevorzugt v_{d} ≥ 20, besonders bevorzugt v_{d} ≥ 24. Auch opto-technische Hybridgläser mit Abbezahlen von v_{d} ≥ 26 können erfindungsgemäß eingesetzt werden.

Die opto-technischen Hybridgläser der vorliegenden Erfindung können verschiedenen Glasklassen angehören. Bevorzugte Glasklassen sind Lanthanborate, Erdalkali-Borosilikate, Lanthan-Borosilikate, Titan-Silikate und Erdalkali-Titansilikate. Im Folgenden werden diese besonders vorteilhaften Gläser näher beschrieben.

Die Gläser dieser Erfindung sind aus den eingangs beschriebenen Gründen frei von Blei. Bevorzugte Ausführungsformen enthalten kein Arsen und insbesondere kein Antimon.

Wenn es in dieser Beschreibung heißt, die opto-technischen Hybridgläser seien frei von einer Komponente oder enthalten eine gewisse Komponente nicht, so ist damit gemeint, dass diese Komponente allenfalls als Verunreinigung in den Gläsern vorliegen darf. Das bedeutet, dass sie nicht in wesentlichen Mengen zugesetzt wird. Nicht wesentliche Mengen sind erfindungsgemäß Mengen von weniger als 100 ppm, bevorzugt weniger als 50 ppm und am meisten bevorzugt weniger als 10 ppm.

### Lanthanboratgläser

Die bevorzugten Lanthanborate weisen Lanthanoxid in Mengen von 25 bis 50 Gew.-% auf. Lanthanoxid ist Teil der hochbrechenden Lanthanboratmatrix. In einem zu geringen Anteil im Glas vorhanden, werden die bevorzugten Brechwertlagen nicht erreicht. Ist sein Anteil zu hoch, steigt die Kristallisationsgefahr wegen fehlender Löslichkeit des Lanthans in der Boratmatrix.

Als Lösungsmittel des Lanthans wird Boroxid verwendet. Es wird vorzugsweise in Mengenanteilen von 7 bis 41 Gew.-%, weiter bevorzugt in Anteilen von 10 bis 38 Gew.-% eingesetzt. Ist der Anteil an Boroxid im bevorzugten Glas zu gering, reicht der Boroxidgehalt nicht aus, um die erforderlichen Mengen des Lanthans zu lösen. Kristallisationsneigung ist die Folge. Wird hingegen eine zu große Menge an Boroxid verwendet, werden die erwünschten hohen Brechwerte nicht erreicht. Außerdem wird durch einen hohen Boroxidanteil die lonenmobilität im Glas erhöht, wodurch wiederum die Kristallisationsneigung steigt. Ferner erhöhen hohe Boroxidanteile im Glas den Eintrag des Feuerfestmaterials während der Herstellung in das Glas. Dies führt zu Inhomogenität, Streuung, heterogenen Keimen und wiederum Kristallisation.

Die bevorzugten Lanthanborate weisen ferner Siliciumdioxid in Gehalten von 0,5 bis 11 Gew.-%, weiter bevorzugt zwischen 1 und 10 Gew.-% auf. Diese Komponente erhöht die chemische Resistenz des Glases. Wird sie jedoch in zu hohen Mengen eingesetzt, verringert sie die Löslichkeit des Lanthans in der Matrix, was zu Kristallisation führen kann.

Aluminiumoxid erhöht ebenfalls die chemische Resistenz des Glases. Es ist in den erfindungsgemäß eingesetzten Lanthanboraten in Mengen von vorzugsweise bis zu 5 Gew.-% enthalten. Wird dieser Anteil jedoch überschritten, so erhöhen sich die Einschmelztemperaturen des Glases, was zu erhöhtem Energieverbrauch und verringerten Aggregatsstandzeiten führt. Ferner wird dadurch ein unerwünscht langes Glas erhalten. In Ausführungsformen der Erfindung ist das Lanthanboratglas daher frei von Aluminiumoxid.

Um einen optimalen Brechwert und optimale Löslichkeit des Lanthans in der Matrix zu erhalten, ist es vorteilhaft, wenn der Gehalt von Lanthanoxid und Boroxid so gewählt wird, dass das Verhältnis von Lanthanoxid zu Boroxid in einem Wertebereich von 0,5 bis 7 angesiedelt ist. Weiter bevorzugt ist ein Verhältnis in einem Bereich von 0,7 bis 5. Werden diese bevorzugten Werte unterschritten, werden Gläser mit zu geringem Brechwert erhalten. Werden die Werte überschritten, neigt das Glas zu Kristallisation.

Ähnliche Überlegungen haben dazu geführt, das Verhältnis von Lanthanoxid zur Summe der Oxide Siliciumdioxid, Boroxid und Aluminiumoxid so zu wählen, dass Werte von 0,5 bis 3, bevorzugt 0,5 bis 5 erhalten werden.

Es ist bevorzugt, dass die Lanthanborate, die erfindungsgemäß verwendet werden können, Lithiumoxid in Gehalten von 0 bis 2 Gew.-%, bevorzugt 0 bis 1,5 Gew.-% aufweisen. Diese Komponente wird zur Feineinstellung der Viskosität verwendet. In Kombination mit Boroxid kann diese Komponente die Herstellungsanlagen stark angreifen, was zu Trübung, heterogener Keimung und geringen Standzeiten der Aggregate führt. Ferner führt Lithiumoxid zu erhöhter lonenmobilität, was wiederum Kristallisation nach sich ziehen kann. Ferner wird chemische Resistenz des Glases verringert. Daher sind bevorzugte Ausführungsformen frei von Lithiumoxid.

Die erfindungsgemäß eingesetzten Lanthanborate können Kaliumoxid umfassen. Kaliumoxid dient der Feineinstellung der Viskosität. Es ist bevorzugt in Mengen von 0 bis 2 Gew.-%, weiter bevorzugt in Mengen von 0 bis 1,5 Gew.-% im Glas enthalten. Ähnlich wie Lithiumoxid führt ein zu großer Anteil am Glas zu erhöhter lonenmobilität und geringer chemische Resistenz. Daher sind bevorzugte Ausführungsformen frei von Kaliumoxid.

Die erfindungsgemäß eingesetzten Lanthanborate können Natriumoxid umfassen. Natriumoxid dient der Feineinstellung der Viskosität. Es ist bevorzugt in Mengen von 0 bis 2 Gew.-%, weiter bevorzugt in Mengen von 0 bis 1,5 Gew.-% im Glas enthalten. Ähnlich wie Lithiumoxid führt ein zu großer Anteil am Glas zu erhöhter Ionenmobilität und geringer chemische Resistenz. Daher sind bevorzugte Ausführungsformen frei von Natriumoxid.

Aus den vorhergehenden Absätzen wird deutlich, dass der Gehalt an Alkalioxiden im erfindungsgemäßen Lanthanboratglas reduziert werden muss, um Kristallisation zu beherrschen. Aus diesem Grund ist der Anteil an den Alkalioxiden Lithiumoxid, Natriumoxid und Kaliumoxid bevorzugt auf einem Gehalt von zusammen höchstens 4 Gew.-%, weiter bevorzugt höchstens 2 Gew.-%, am meisten bevorzugt höchstens 1 Gew.-% begrenzt. Besondere Ausführungsformen sind sogar frei von Alkalioxiden.

Ausführungsformen der Lanthanborate weisen Magnesiumoxid auf. Bevorzugt liegt dessen Gehalt bei bis zu 5 Gew.-%, weiter bevorzugt bis zu 2 Gew.-%. Magnesiumoxid wird eingesetzt, um die Viskosität des Glases einzustellen. Wird zu viel Magnesiumoxid eingesetzt, erhöht dies die Kristallisationsneigung der Gläser. Deshalb sind bevorzugte Ausführungsformen frei von Magnesiumoxid.

Die Lanthanborate können Strontiumoxid umfassen. Dieses liegt dann in Mengen von bis zu 5 Gew.-% vor, bevorzugte Ausführungsformen weisen höchstens 2 Gew.-% auf, um die Viskosität des Glases einzustellen. Wird zu viel Strontiumoxid eingesetzt, werden zu kurze Gläser erhalten. Daher sind bevorzugte Ausführungsformen frei von Strontiumoxid.

Die Lanthanborate können Calciumoxid enthalten, um die Abhängigkeit der Viskosität von der Temperatur einzustellen. Zu diesem Zweck wird Calciumoxid in Mengen von bis zu 17 Gew.-% eingesetzt, bevorzugte Ausführungsformen weisen bis zu 10 Gew.-% auf. Wird zu viel Calciumoxid eingesetzt, wird ein zu kurzes Glas erhalten.

Die Lanthanborate können auch Bariumoxid umfassen. Bariumoxid erhöht den Brechwert der Gläser und dient der Einstellung der Abhängigkeit der Viskosität von der Temperatur. Zu diesem Zweck wird Bariumoxid in Mengen von 0 bis 7 Gew.-%, bevorzugt 0 bis 5 Gew.-%e eingesetzt. Wird indes zu viel Bariumoxid verwendet, wird ein zu kurzes Glas erhalten.

Um die Länge des Glases optimal einzustellen, soll der Anteil der Summe der oben beschriebenen Erdalkalioxide vorzugsweise einen Wert von 20 Gew.-% nicht überschreiten, weiter bevorzugt sind bis zu 10 Gew.-%. In bevorzugten Ausführungsformen weisen die Lanthanboratgläser wenigstens 2 Gew.-%, weiter bevorzugt wenigstens 4 Gew.-% Erdalkalioxide auf.

Um die optische Lage des Lanthanboratglases optimal einzustellen, können Titanoxid und/oder Zirkonoxid verwendet werden. Dabei liegt deren Gehalt in Summe bei bis zu 18 Gew.-%. In bevorzugten Ausführungsformen liegt ihr Gehalt bei 3 bis 16 Gew.-%. Besonders bevorzugt sind Gehalte von 5 bis 15 Gew.-%. Dabei liegt jeweils der Gehalt der Einzelkomponenten bei vorzugsweise 0 bis 10 Gew.-%, weiter bevorzugt 0 bis 9 Gew.-%. Werden diese Komponenten in zu großer Menge eingesetzt, erhöht sich die Kristallisationsneigung der Gläser.

Die erfindungsgemäßen Gläser können Yttriumoxid in Mengen von 0 bis 20 Gew.-%, bevorzugt 0 bis 15, mehr bevorzugt 0 bis 10 und am meisten bevorzugt 0 bis 5 Gew.-% umfassen. Gleiches gilt für die Komponenten Ytterbiumoxid, Gadoliniumoxid und Tantaloxid. Die Komponente Nioboxid kann in Mengen von 0 bis 20 Gew.-%, bevorzugt 0 bis 15 Gew.-%, weiter bevorzugt 0 bis 10 Gew.-% und mehr bevorzugt 0 bis 5 Gew.-% vorliegen. Die in diesem Absatz genannten Komponenten dienen der Einstellung der erfindungsgemäß benötigten hohen Brechwerte. Es ist allerdings zu berücksichtigen, dass die Mengen, in denen diese Komponenten eingesetzt werden, begrenzt werden müssen, weil ansonsten eine verringerte Transmission aufgrund einer Verschiebung der UV-Kante zu befürchten ist. Ferner führen zu große Mengen zu Kristallwachstum. Dabei sind bevorzugte Ausführungsformen gänzlich frei von Nioboxid, weil dieses im Floatprozess reduziert werden kann. Es hat sich erwiesen, dass die hier diskutierten Oxide am besten in Mengen von zusammen 0 bis 36 Gew.-%, bevorzugt 0 bis 20 Gew.-%, weiter bevorzugt 0 bis 10 Gew.-% und am meisten bevorzugt 0 bis 5 Gew.-% eingesetzt werden. Zu berücksichtigen ist auch, dass diese hier genannten Komponenten sehr teuer sind und auch aus diesem Grund die eingesetzte Menge begrenzt werden sollte.

Besonders bevorzugte Lanthanboratgläser diese Erfindung haben folgende Zusammensetzung in Gew.-%:

| | |
|---|---|
| La₂O₃ | 25 bis 50 |
| B₂O₃ | 7 bis 41 |
| SiO₂ | 0,5 bis 11 |
| Al₂O₃ | 0 bis 5 |
| La₂O₃/B₂O₃ | 0,5 bis 7 |
| La₂O₃/(SiO₂+B₂O₃+Al₂O₃) | 0,5 bis 3 |
| Li₂O | 0 bis 2 |
| K₂O | 0 bis 2 |
| Na₂O | 0 bis 2 |
| Li₂O+Na₂O+K₂O | 0 bis 4 |
| MgO | 0 bis 5 |
| SrO | 0 bis 5 |
| CaO | 0 bis 17 |
| BaO | 0 bis 7 |
| MgO+CaO+SrO+BaO | 0 bis 20 |
| TiO₂ | 0 bis 10 |
| ZrO₂ | 0 bis 10 |
| TiO₂ + ZrO₂ | 0 bis 18 |
| Y₂O₃ | 0 bis 20 |
| Yb₂O₃ | 0 bis 20 |
| Gd₂O₃ | 0 bis 20 |
| Ta₂O₅ | 0 bis 20 |
| Nb₂O₅ | 0 bis 20 |
| Y₂O₃+Yb₂O₃+Gd₂O₃+Ta₂O₅+Nb₂O₅ | 0 bis 36 |

In weiter bevorzugten Ausführungsformen haben die Lanthanboratgläser folgende Zusammensetzung in Gew.-%:

| | |
|---|---|
| La₂O₃ | 25 bis 50 |
| B₂O₃ | 10 bis 38 |
| SiO₂ | 1,0 bis 10 |
| La₂O₃/B₂O₃ | 0,7 bis 5 |
| La₂O₃/(SiO₂+B₂O₃+Al₂O₃) | 0,5 bis 5 |
| Li₂O | 0 bis 1,5 |
| K₂O | 0 bis 1,5 |
| Na₂O | 0 bis 1,5 |
| Li₂O+Na₂O+K₂O | 0 bis 2 |
| MaO | 0 bis 2 |
| SrO | 0 bis 2 |
| CaO | 0 bis 10 |
| BaO | 0 bis 5 |
| MgO+CaO+SrO+BaO | 0 bis 10 |
| TiO₂ | 0 bis 9 |
| ZrO₂ | 0 bis 9 |
| TiO₂ + ZrO₂ | 3 bis 16 |
| Y₂O₃ | 0 bis 15 |
| Yb₂O₃ | 0 bis 15 |
| Gd₂O₃ | 0 bis 15 |
| Ta₂O₅ | 0 bis 15 |
| Nb₂O₅ | 0 bis 15 |
| Y₂O₃+Yb₂O₃+Gd₂O₃+Ta₂O₅+Nb₂O₅ | 0 bis 20 |

### Erdalkali-Borosilikatgläser

Es hat sich gezeigt, dass auch Borosilikatgläser geeignet sind, erfindungsgemäß eingesetzt zu werden. In einer bevorzugten Ausführungsform ist das Hybridglas ein Erdalkali-Borosilikatglas.

Als Glasbildner wir unter anderem Boroxid verwendet, das auch die Einschmelztemperaturen verringert. Es wird vorzugsweise in Mengenanteilen von 1 bis 21 Gew.-%, weiter bevorzugt in Anteilen von 3 bis 20 Gew.-% eingesetzt, in besonders bevorzugten Ausführungsformen wird es in Mengen von 5 bis 15 Gew.-% verwendet. Ist der Anteil an Boroxid im bevorzugten Glas zu gering, wird die Viskosität des Glases zu hoch. Wird hingegen eine zu große Menge an Boroxid verwendet, werden die erwünschten hohen Brechwerte nicht erreicht. Außerdem wird durch einen hohen Boroxidanteil die lonenmobilität im Glas erhöht, wodurch wiederum die Kristallisationsneigung steigt. Ferner erhöhen hohe Boroxidanteile im Glas den Eintrag des Feuerfestmaterials während der Herstellung in das Glas. Dies führt zu Inhomogenität, Streuung, heterogenen Keimen und wiederum Kristallisation.

Die bevorzugten Erdalkali-Borosilikatgläser weisen ferner Siliciumdioxid als Glasbildner in Gehalten von 25 bis 65 Gew.-%, weiter bevorzugt 30 bis 60 Gew.-%, am meisten bevorzugt 35 bis 55 Gew.-% auf. Diese Komponente erhöht die chemische Resistenz und Härte des Glases. Wird sie jedoch in zu hohen Mengen eingesetzt, werden die hohen Brechwerte nicht erreicht und hohe Einschmelztemperaturen erschweren den Herstellungsprozess.

Aluminiumoxid erhöht ebenfalls die chemische Resistenz des Glases. Es ist in den erfindungsgemäß eingesetzten Erdalkali-Borosilikatgläsern in Mengen von vorzugsweise bis zu 8 Gew.-%, weiter bevorzugt bis zu 6 Gew.-% enthalten. Wird dieser Anteil jedoch überschritten, so erhöhen sich die Einschmelztemperaturen des Glases, was zu erhöhtem Energieverbrauch und verringerten Aggregatsstandzeiten führt. Ferner wird dadurch ein unerwünscht langes Glas erhalten. In Ausführungsformen der Erfindung ist das Erdalkali-Borosilicatglas daher frei von Aluminiumoxid.

Zur Ausbildung der Glasmatrix dienen Siliciumdioxid und Boroxid; es ist vorteilhaft, wenn der Gehalt von Siliciumdioxid und Boroxid so gewählt wird, dass die Summe von Siliciumdioxid und Boroxid in einem Wertebereich von 35 bis 66 Gew.-% angesiedelt ist. Weiter bevorzugt ist eine Summe in einem Bereich von 40 bis 64 Gew.-%. Werden diese bevorzugten Werte unterschritten, werden Gläser mit zu geringem Brechwert erhalten. Außerdem würde ein solches Glas zu Kristallisation neigen und die Eigenschaften eines langen Glases aufweisen. Aus den gleichen Überlegungen sollte die Summe von Siliciumdioxid, Boroxid und Aluminiumoxid (=Summe der Glasbildner) in einem Bereich von 41 bis 68 Gew.-%, bevorzugt 48 bis 65 Gew.-% liegen.

Es ist bevorzugt, dass die Erdalkali-Borosilikate, die erfindungsgemäß verwendet werden können, Lithiumoxid in Gehalten von 0 bis 10 Gew.-%, bevorzugt 0 bis 8 Gew.-% aufweisen. Diese Komponente wird zur Feineinstellung der Viskosität verwendet. In Kombination mit Boroxid kann diese Komponente die Herstellungsanlagen stark angreifen, was zu Trübung, heterogener Keimung und geringen Standzeiten der Aggregate führt. Ferner führt Lithiumoxid zu erhöhter lonenmobilität, was wiederum Kristallisation nach sich ziehen kann. Außerdem wird die chemische Resistenz des Glases verringert.

Die erfindungsgemäß eingesetzten Erdalkali-Borosilikate können Kaliumoxid umfassen. Kaliumoxid dient der Feineinstellung der Viskosität. Es ist bevorzugt in Mengen von 0 bis 10 Gew.-% im Glas enthalten. Ähnlich wie bei Lithiumoxid führt ein zu großer Anteil am Glas zu erhöhter lonenmobilität und geringer chemischer Resistenz.

Die erfindungsgemäß eingesetzten Erdalkali-Borosilikate können Natriumoxid umfassen. Natriumoxid dient der Feineinstellung der Viskosität. Es ist bevorzugt in Mengen von 0 bis 10 Gew.-% im Glas enthalten. Ähnlich wie Lithiumoxid führt ein zu großer Anteil am Glas zu erhöhter Ionenmobilität und geringer chemische Resistenz. Daher sind bevorzugte Ausführungsformen frei von Natriumoxid.

Aus den vorhergehenden Absätzen wird deutlich, dass der Gehalt an Alkalioxiden im erfindungsgemäßen Erdalkali-Borosilikatglas begrenzt werden muss, um Feineinstellungen an der Viskosität vorzunehmen. Aus diesem Grund ist der Anteil an den Alkalioxiden Lithiumoxid, Natriumoxid und Kaliumoxid bevorzugt auf einem Gehalt von höchstens 15 Gew.-%, weiter bevorzugt höchstens 13 Gew.-% begrenzt. In bevorzugten Ausführungsformen ist das Glas frei von Alkalioxiden.

Ausführungsformen der Erdalkali-Borosilikate weisen Magnesiumoxid auf. Bevorzugt liegt dessen Gehalt bei bis zu 5 Gew.-%, weiter bevorzugt bis zu 2 Gew.-%. Magnesiumoxid wird eingesetzt, um die Viskosität des Glases einzustellen. Wird zu viel Magnesiumoxid eingesetzt, erhöht dies die Kristallisationsneigung der Gläser. Deshalb sind bevorzugte Ausführungsformen frei von Magnesiumoxid.

Die Erdalkali-Borosilikate können Strontiumoxid umfassen. Dieses liegt dann in Mengen von bis zu 10 Gew.-% vor, bevorzugte Ausführungsformen weisen höchstens 9 Gew.-% auf, um die Viskosität des Glases einzustellen. Wird zu viel Strontiumoxid eingesetzt, werden zu kurze Gläser erhalten.

Die Erdalkali-Borosilikate können Calciumoxid enthalten, um die Abhängigkeit der Viskosität von der Temperatur einzustellen. Zu diesem Zweck wird Calciumoxid in Mengen von bis zu 10 Gew.-% eingesetzt, bevorzugte Ausführungsformen weisen bis zu 9 Gew.-% auf. Wird zu viel Calciumoxid eingesetzt, wird ein zu kurzes Glas erhalten.

Die Erdalkali-Borosilikate können auch Bariumoxid umfassen. Bariumoxid erhöht den Brechwert der Gläser und dient der Einstellung der Abhängigkeit der Viskosität von der Temperatur. Zu diesem Zweck wird Bariumoxid in Mengen von 10 bis 50 Gew.-%, bevorzugt 11 bis 48 Gew.-%, mehr bevorzugt 15 bis 45 Gew.-% eingesetzt. Wird indes zu viel Bariumoxid verwendet, wird ein zu kurzes Glas erhalten. Wird zu wenig verwendet, ist der Brechwert der so erhaltenen Gläser zu gering, das Glas zu lang.

Um die Länge des Glases optimal einzustellen, soll der Anteil der Summe der oben beschriebenen Erdalkalioxide vorzugsweise einen Wert von 10 bis 52 Gew.-% annehmen, weiter bevorzugt sind 13 bis 52 Gew.-%, am meisten bevorzugt sind 15 bis 45 Gew.-%.

Vorzugsweise liegt der Anteil der Summe der Erdalkalioxide und der Glasbildner zusammen bei wenigstens 75 Gew.-%, mehr bevorzugt wenigstens 78 Gew.-%. In anderen Ausführungsformen liegt dieser Anteil bei 70-100 Gew.-%, mehr bevorzugt 73-100 Gew.-%. Es hat sich gezeigt, dass dadurch eine geeignete Glasmatrix für die erfindungsgemäße Verwendung bereitgestellt werden kann.

Um die optische Lage des Erdalkali-Borosilikatglases einzustellen, können Titanoxid und/oder Zirkonoxid verwendet werden. Dabei liegt deren Gehalt in Summe bei bis zu 12 Gew.-%. In bevorzugten Ausführungsformen liegt ihr Gehalt bei bis zu 10 Gew.-%, am meisten bevorzugt bei bis zu 8 Gew.-%. Dabei liegt der Gehalt an Titanoxid bei vorzugsweise 0 bis 12 Gew.-%, der von Zirkonoxid bevorzugt bei 0 bis 8 Gew.-%. Werden diese Komponenten in zu großer Menge eingesetzt, erhöht sich die Kristallisationsneigung der Gläser.

Die erfindungsgemäßen Gläser können Yttriumoxid in Mengen von 0 bis 5 Gew.-% umfassen. Gleiches gilt für die Komponenten Ytterbiumoxid, Gadoliniumoxid, Nioboxid, Lanthanoxid und Tantaloxid. Die in diesem Absatz genannten Komponenten dienen der Einstellung der erfindungsgemäß benötigten hohen Brechwerte. Es ist allerdings zu berücksichtigen, dass die Mengen, in denen diese Komponenten eingesetzt werden, begrenzt werden müssen, weil ansonsten eine verringerte Transmission aufgrund einer Verschiebung der UV-Kante zu befürchten ist. Ferner führen zu große Mengen zu Kristallwachstum. Dabei sind bevorzugte Ausführungsformen gänzlich frei von Nioboxid, weil dieses im Floatprozess reduziert werden kann. Es hat sich erwiesen, dass die hier diskutierten Oxide am besten in Mengen von 0 bis 8 Gew.-%, bevorzugt 0 bis 3 Gew.-% im Erdalkali-Borosilikatglas eingesetzt werden. Zu berücksichtigen ist auch, dass diese hier genannten Komponenten sehr teuer sind und auch aus diesem Grund die eingesetzte Menge begrenzt werden sollte.

Besonders bevorzugte Erdalkali-Borosilikatgläser haben folgende Zusammensetzung in Gew.-%:

| | |
|---|---|
| SiO₂ | 25 bis 65 |
| B₂O₃ | 1 bis 21 |
| Al₂O₃ | 0 bis 8 |
| SiO₂+B₂O₃ | 35 bis 66 |
| SiO₂+B₂O₃+Al₂O₃ | 48 bis 68 |
| Li₂O | 0 bis 10 |
| K₂O | 0 bis 10 |
| Na₂O | 0 bis 10 |
| Li₂O+Na₂O+K₂O | 0 bis 15 |
| MgO | 0 bis 5 |
| CaO | 0 bis 10 |
| SrO | 0 bis 10 |
| BaO | 10 bis 50 |
| MgO+CaO+SrO+BaO | 10 bis 52 |
| MgO+CaO+SrO+BaO+SiO₂+B₂O₃+Al₂O₃ | 70 bis 100 |
| TiO₂ | 0 bis 12 |
| ZrO₂ | 0 bis 8 |
| TiO₂ + ZrO₂ | 0 bis 12 |
| La₂O₃ | 0 bis 5 |
| Y₂O₃ | 0 bis 5 |
| Yb₂O₃ | 0 bis 5 |
| Gd₂O₃ | 0 bis 5 |
| Ta₂O₅ | 0 bis 5 |
| Nb₂O₅ | 0 bis 5 |
| Y₂O₃+Yb₂O₃+Gd₂O₃+Ta₂O₅+Nb₂O₅ | 0 bis 8 |

In weiter bevorzugten Ausführungsformen haben die Erdalkali-Borosilikatgläser folgende Zusammensetzung in Gew.-%:

| | |
|---|---|
| SiO₂ | 30 bis 60 |
| B₂O₃ | 3 bis 20 |
| Al₂O₃ | 0 bis 6 |
| SiO₂+B₂O₃ | 40 bis 64 |
| SiO₂+B₂O₃+Al₂O₃ | 41 bis 65 |
| Li₂O | 0 bis 8 |
| K₂O | 0 bis 10 |
| Na₂O | 0 bis 10 |
| Li₂O+Na₂O+K₂O | 0 bis 13 |
| MgO | 0 bis 2 |
| CaO | 0 bis 9 |
| SrO | 0 bis 9 |
| BaO | 11 bis 48 |
| MgO+CaO+SrO+BaO | 13 bis 52 |
| GB+MO | 73 bis 100 |
| TiO₂ | 0 bis 12 |
| ZrO₂ | 0 bis 8 |
| TiO₂ + ZrO₂ | 0 bis 12 |
| La₂O₃ | 0 bis 5 |
| Y₂O₃ | 0 bis 5 |
| Yb₂O₃ | 0 bis 5 |
| Gd₂O₃ | 0 bis 5 |
| Ta₂O₅ | 0 bis 5 |
| Nb₂O₅ | 0 bis 5 |
| Y₂O₃+Yb₂O₃+Gd₂O₃+Ta₂O₅+Nb₂O₅ | 0 bis 3 |

### Lanthan-Borosilikatgläser

In einer anderen Ausführungsform ist das Hybridglas ein Lanthan-Borosilikatglas.

Als Glasbildner und Lösungsmittel für das Lanthan wird Boroxid verwendet, das auch die Einschmelztemperaturen verringert. Es wird vorzugsweise in Mengenanteilen von 2 bis 52 Gew.-%, weiter bevorzugt in Anteilen von 2 bis 50 Gew.-% eingesetzt, in besonders bevorzugten Ausführungsformen wird es in Mengen von 5 bis 45 Gew.-% verwendet. Ist der Anteil an Boroxid im bevorzugten Glas zu gering, wird die Viskosität des Glases zu hoch. Wird hingegen eine zu große Menge an Boroxid verwendet, werden die erwünschten hohen Brechwerte nicht erreicht. Außerdem wird durch einen hohen Boroxidanteil die lonenmobilität im Glas erhöht, wodurch wiederum die Kristallisationsneigung steigt. Ferner erhöhen hohe Boroxidanteile im Glas den Eintrag des Feuerfestmaterials während der Herstellung in das Glas. Dies führt zu Inhomogenität, Streuung, heterogenen Keimen und wiederum Kristallisation.

Die bevorzugten Lanthan-Borosilikatgläser weisen ferner Siliciumdioxid als Glasbildner in Gehalten von 6 bis 35 Gew.-%, weiter bevorzugt 9 bis 33 Gew.-%, am meisten bevorzugt 12 bis 30 Gew.-% auf. Diese Komponente erhöht die chemische Resistenz und Härte des Glases. Wird sie jedoch in zu hohen Mengen eingesetzt, werden die hohen Brechwerte nicht erreicht und hohe Einschmelztemperaturen erschweren den Herstellungsprozess.

Aluminiumoxid erhöht ebenfalls die chemische Resistenz des Glases. Es ist in den erfindungsgemäß eingesetzten Lanthan-Borosilikatgläsern in Mengen von vorzugsweise bis zu 6 Gew.-%, weiter bevorzugt ist zu 4 Gew.-%, am meisten bevorzugt 2 Gew.-% enthalten. Wird dieser Anteil jedoch überschritten, so erhöhen sich die Einschmelztemperaturen des Glases, was zu erhöhtem Energieverbrauch und verringerten Aggregatsstandzeiten führt. Ferner wird dadurch ein unerwünscht langes Glas erhalten. In Ausführungsformen der Erfindung ist das Lanthan-Borosilikatglas daher frei von Aluminiumoxid.

Zur Ausbildung der Glasmatrix dienen neben Lanthanoxid Siliciumdioxid und Boroxid; es ist vorteilhaft, wenn der Gehalt von Siliciumdioxid und Boroxid so gewählt wird, dass die Summe von Siliciumdioxid und Boroxid in einem Wertebereich von 20 bis 60 Gew.-% angesiedelt ist. Weiter bevorzugt ist eine Summe in einem Bereich von 22 bis 60 Gew.-%. Werden diese bevorzugten Werte unterschritten, werden Gläser mit zu geringem Brechwert erhalten. Außerdem würde ein solches Glas zu Kristallisation neigen und die Eigenschaften eines langen Glases aufweisen. Aus den gleichen Überlegungen sollte die Summe von Siliciumdioxid, Boroxid und Aluminiumoxid (=Summe der Glasbildner) in einem Bereich von 20 bis 60 Gew.-%, bevorzugt 22 bis 60 Gew.-% liegen.

Die bevorzugten Lanthan-Borosilikate weisen Lanthanoxid in Mengen von 3 bis 25 Gew.-%, weiter bevorzugt 5 bis 25 Gew.-% und am meisten bevorzugt 8 bis 20 Gew.-% auf. Lanthanoxid ist Teil der hochbrechenden Lanthan-Borosilikatmatrix. In einem zu geringen Anteil im Glas vorhanden, werden die bevorzugten Brechwertlagen nicht erreicht. Ist sein Anteil zu hoch, steigt die Kristallisationsgefahr wegen fehlender Löslichkeit des Lanthans in der Boratmatrix.

Es ist bevorzugt, dass die Lanthan-Borosilikate, die erfindungsgemäß verwendet werden können, Lithiumoxid in Gehalten von 0 bis 2 Gew.-% aufweisen. Diese Komponente wird zur Feineinstellung der Viskosität verwendet. In Kombination mit Boroxid kann diese Komponente die Herstellungsanlagen stark angreifen, was zu Trübung, heterogener Keimung und geringen Standzeiten der Aggregate führt. Ferner führt Lithiumoxid zu erhöhter lonenmobilität, was wiederum Kristallisation nach sich ziehen kann. Außerdem wird die chemische Resistenz des Glases verringert. Daher sind bevorzugte Ausführungsformen frei von Lithiumoxid.

Die erfindungsgemäß eingesetzten Lanthan-Borosilikate können Kaliumoxid umfassen. Kaliumoxid dient der Feineinstellung der Viskosität. Es ist bevorzugt in Mengen von 0 bis 2 Gew.-% im Glas enthalten. Ähnlich wie bei Lithiumoxid führt ein zu großer Anteil am Glas zu erhöhter lonenmobilität und geringer chemische Resistenz. Daher sind bevorzugte Lanthan-Borosilikatgläser frei von Kaliumoxid.

Die erfindungsgemäß eingesetzten Lanthan-Borosilikate können Natriumoxid umfassen. Natriumoxid dient der Feineinstellung der Viskosität. Es ist bevorzugt in Mengen von 0 bis 2 Gew.-% im Glas enthalten. Ähnlich wie Lithiumoxid führen zu große Anteile am Glas zu erhöhter lonenmobilität und geringer chemische Resistenz. Daher sind bevorzugte Ausführungsformen frei von Natriumoxid.

Aus den vorhergehenden Absätzen wird deutlich, dass der Gehalt an Alkalioxiden im erfindungsgemäßen Lanthan-Borosilikatglas begrenzt werden muss, um Feineinstellungen an der Viskosität vorzunehmen. Aus diesem Grund ist der Anteil an den Alkalioxiden Lithiumoxid, Natriumoxid und Kaliumoxid bevorzugt auf einen Gehalt von höchstens 4 Gew.-%, weiter bevorzugt 2 Gew.-% begrenzt. Bevorzugte Ausführungsformen sind frei von Alkalioxiden.

Ausführungsformen der Lanthan-Borosilikate weisen Magnesiumoxid auf. Bevorzugt liegt dessen Gehalt bei bis zu 5 Gew.-%, weiter bevorzugt bis zu 3 Gew.-%. Magnesiumoxid wird eingesetzt, um die Viskosität des Glases einzustellen. Wird zu viel Magnesiumoxid verwendet, erhöht dies die Kristallisationsneigung der Gläser. Deshalb sind bevorzugte Ausführungsformen frei von Magnesiumoxid.

Die Lanthan-Borosilikate können Strontiumoxid umfassen. Dieses liegt dann in Mengen von bis zu 10 Gew.-% vor, um die Viskosität des Glases einzustellen. Wird zu viel Strontiumoxid eingesetzt, werden zu kurze Gläser erhalten.

Die Lanthan-Borosilikate können Calciumoxid enthalten, um die Abhängigkeit der Viskosität von der Temperatur einzustellen. Zu diesem Zweck wird Calciumoxid in Mengen von bis zu 35 Gew.-% eingesetzt. Wird zu viel Calciumoxid eingesetzt, wird ein zu kurzes Glas erhalten.

Die Lanthan-Borosilikate können auch Bariumoxid umfassen. Bariumoxid erhöht den Brechwert der Gläser und dient der Einstellung der Abhängigkeit der Viskosität von der Temperatur. Zu diesem Zweck wird Bariumoxid in Mengen von 0,5 bis 50 Gew.-%, bevorzugt 2 bis 50 Gew.-%, mehr bevorzugt 5 bis 45 Gew.-% eingesetzt. Wird indes zu viel Bariumoxid verwendet, wird ein zu kurzes Glas erhalten. Wird zu wenig verwendet, ist der Brechwert der so erhaltenen Gläser zu gering, das Glas zu lang.

Um die Länge des Glases optimal einzustellen, soll der Anteil der Summe der oben beschriebenen Erdalkalioxide vorzugsweise einen Wert von 24 bis 50 Gew.-% annehmen, weiter bevorzugt sind 28 bis 45 Gew.-%.

Vorzugsweise liegt der Anteil der Summe der Erdalkalioxide und der Glasbildner zusammen bei 40 bis 97 Gew.-%, weiter bevorzugt 44 bis 97 Gew.-%. Weiterhin ist bevorzugt, dass die Summe der Erdalkalioxide, Glasbildner und Lanthanoxid zusammen in einem Bereich von 65 bis 100 Gew.-%, weiter bevorzugt in einem Bereich von 68 bis 100 Gew.-% liegt. Es hat sich gezeigt, dass dadurch eine geeignete Glasmatrix für die erfindungsgemäße Verwendung bereitgestellt werden kann.

Um die optische Lage des Lanthan-Borosilikatglases einzustellen, können Titanoxid und/oder Zirkonoxid verwendet werden. Dabei liegt deren Gehalt in Summe bei bis zu 18 Gew.-%. In bevorzugten Ausführungsformen liegt ihr Gehalt bei bis zu 15 Gew.-%, am meisten bevorzugt bei bis zu 10 Gew.-%. Dabei liegt der Gehalt an Titanoxid bei vorzugsweise 0 bis 12 Gew.-%, weiter bevorzugt 0 bis 10 Gew.-%; der von Zirkonoxid bevorzugt bei 0 bis 8 Gew.-%, weiter bevorzugt 0 bis 6 Gew.-%. Werden diese Komponenten in zu großer Menge eingesetzt, erhöht sich die Kristallisationsneigung der Gläser.

Die erfindungsgemäßen Gläser können Yttriumoxid in Mengen von 0 bis 5 Gew.-%, bevorzugt 0 bis 3 Gew.-% umfassen. Gleiches gilt für die Komponenten Ytterbiumoxid, Gadoliniumoxid und Tantaloxid. Die in diesem Absatz genannten Komponenten dienen der Einstellung der erfindungsgemäß benötigten hohen Brechwerte. Es ist allerdings zu berücksichtigen, dass die Mengen, in denen diese Komponenten eingesetzt werden, begrenzt werden müssen, weil ansonsten eine verringerte Transmission aufgrund einer Verschiebung der UV-Kante zu befürchten ist. Ferner führen zu große Mengen zu Kristallwachstum. Erfindungsgemäß kann das Lanthan-Borosilikatglas Nioboxid in Mengen von 0 bis 8 Gew.-%, bevorzugt bis zu 5 Gew.-% enthalten. Dabei sind bevorzugte Ausführungsformen gänzlich frei von Nioboxid, weil dieses im Floatprozess reduziert werden kann. Es hat sich erwiesen, dass die hier diskutierten Oxide am besten in Mengen von zusammen 0 bis 15 Gew.-%, bevorzugt 0 bis 8 Gew.-% im Lanthan-Borosilikatglas eingesetzt werden. Zu berücksichtigen ist auch, dass diese hier genannten Komponenten sehr teuer sind und auch aus diesem Grund die eingesetzte Menge begrenzt werden sollte.

Ein besonders bevorzugtes Lanthan-Borosilikatglas gemäß der vorliegenden Erfindung hat folgende Zusammensetzung in Gew.-%:

| | |
|---|---|
| SiO₂ | 6 bis 35 |
| B₂O₃ | 2 bis 52 |
| Al₂O₃ | 0 bis 6 |
| SiO₂+B₂O₃ | 20 bis 60 |
| SiO₂+B₂O₃+Al₂O₃ | 20 bis 60 |
| La₂O₃ | 3 bis 25 |
| Li₂O | 0 bis 2 |
| K₂O | 0 bis 2 |
| Na₂O | 0 bis 2 |
| Li₂O+Na₂O+K₂O | 0 bis 4 |
| MgO | 0 bis 5 |
| CaO | 0 bis 35 |
| SrO | 0 bis 10 |
| BaO | 0,5 bis 50 |
| MgO+CaO+SrO+BaO | 24 bis 50 |
| SiO₂+B₂O₃+Al₂O₃+MgO+CaO+SrO+BaO | 40 bis 97 |
| SiO₂+B₂O₃+Al₂O₃+MgO+CaO+SrO+BaO+La₂O₃ | 65 bis 100 |
| TiO₂ | 0 bis 12 |
| ZrO₂ | 0 bis 8 |
| TiO₂ + ZrO₂ | 0 bis 18 |
| Y₂O₃ | 0 bis 5 |
| Yb₂O₃ | 0 bis 5 |
| Gd₂O₃ | 0 bis 5 |
| Ta₂O₅ | 0 bis 5 |
| Nb₂O₅ | 0 bis 8 |
| Y₂O₃+Yb₂O₃+Gd₂O₃+Ta₂O₅+Nb₂O₅ | 0 bis 15 |

In weiter bevorzugten Ausführungsformen hat das Lanthan-Borosilikatglas folgende Zusammensetzung in Gew.-%:

| | |
|---|---|
| SiO₂ | 9 bis 33 |
| B₂O₃ | 2 bis 50 |
| Al₂O₃ | 0 bis 4 |
| SiO₂+B₂O₃ | 22 bis 60 |
| SiO₂+B₂O₃+Al₂O₃ | 22 bis 60 |
| La₂O₃ | 3 bis 25 |
| Li₂O | 0 bis 2 |
| K₂O | 0 bis 2 |
| Na₂O | 0 bis 2 |
| Li₂O+Na₂O+K₂O | 0 bis 2 |
| MgO | 0 bis 3 |
| CaO | 0 bis 35 |
| SrO | 0 bis 10 |
| BaO | 0,5 bis 50 |
| MgO+CaO+SrO+BaO | 24 bis 50 |
| SiO₂+B₂O₃+Al₂O₃+MgO+CaO+SrO+BaO | 44 bis 97 |
| SiO₂+B₂O₃+Al₂O₃+MgO+CaO+SrO+BaO+La₂O | 68 bis 100 |
| TiO₂ | 0 bis 10 |
| ZrO₂ | 0 bis 6 |
| Y₂O₃ | 0 bis 3 |
| Yb₂O₃ | 0 bis 3 |
| Gd₂O₃ | 0 bis 3 |
| Ta₂O₅ | 0 bis 3 |
| Nb₂O₅ | 0 bis 8 |
| Y₂O₃+Yb₂O₃+Gd₂O₃+Ta₂O₅+Nb₂O₅ | 0 bis 8 |

### Titan-Silikatgläser

In anderen erfindungsgemäßen Ausführungsformen ist das opto-technische Hybridglas ein Silikatglas, insbesondere Titan-Silikatglas.

In den Titan-Silikatgläsern wird Siliciumdioxid als Hauptglasbildner in Gehalten von 50 bis 75 Gew.-%, weiter bevorzugt 50 bis 70 Gew.-%, am meisten bevorzugt 55 bis 65 Gew.-% verwendet. Diese Komponente erhöht die chemische Resistenz und Härte des Glases. Wird sie jedoch in zu großen Mengen eingesetzt, werden die hohen Brechwerte nicht erreicht und hohe Einschmelztemperaturen erschweren den Herstellungsprozess.

Als weiterer Glasbildner wird Boroxid verwendet, das auch die Einschmelztemperaturen verringert. Es wird vorzugsweise in Mengenanteilen von 0 bis 10 Gew.-%, weiter bevorzugt in Anteilen von 0 bis 8 Gew.-% eingesetzt, in besonders bevorzugten Ausführungsformen wird es in Mengen von bis zu 7 Gew.-% verwendet. Ist der Anteil an Boroxid im bevorzugten Glas zu gering, wird die Viskosität des Glases zu hoch. Wird hingegen eine zu große Menge an Boroxid verwendet, werden die erwünschten hohen Brechwerte nicht erreicht. Außerdem wird durch einen hohen Boroxidanteil die lonenmobilität im Glas erhöht, wodurch wiederum die Kristallisationsneigung steigt. Ferner erhöhen hohe Boroxidanteile im Glas den Eintrag des Feuerfestmaterials während der Herstellung in das Glas. Dies führt zu Inhomogenität, Streuung, heterogenen Keimen und wiederum Kristallisation.

Aluminiumoxid erhöht ebenfalls die chemische Resistenz und Abriebhärte des Glases. Es ist in den erfindungsgemäß eingesetzten Titan-Silikatgläsern in Mengen von vorzugsweise bis zu 10 Gew.-%, weiter bevorzugt ist zu 9 Gew.-% und ganz besonders bevorzugt bis zu 7 Gew.-% enthalten. Wird dieser Anteil jedoch überschritten, so erhöhen sich die Einschmelztemperaturen des Glases, was zu erhöhtem Energieverbrauch und verringerten Aggregatsstandzeiten führt. Ferner wird dadurch ein unerwünscht langes Glas erhalten.

Zur Ausbildung der Glasmatrix dienen neben Siliciumdioxid Aluminiumoxid und Boroxid; es ist vorteilhaft, wenn der Gehalt von Aluminiumoxid und Boroxid so gewählt wird, dass die Summe von Aluminiumoxid und Boroxid in einem Wertebereich von 0 bis 15 Gew.-% angesiedelt ist. Weiter bevorzugt ist eine Summe in einem Bereich von 0 bis 12 Gew.-%, besonders bevorzugt 0 bis 10 Gew.-%. Werden diese Werte überschritten, leidet die Kristallisationsstabilität der Gläser. Um jedoch eine ausreichende Stabilität zu gewährleisten sollte die Summe von Siliciumdioxid, Boroxid und Aluminiumoxid (=Summe der Glasbildner) in einem Bereich von 50 bis 75 Gew.-%, bevorzugt 52 bis 73 Gew.-%, am meisten bevorzugt 55 bis 70 Gew.-% liegen. Der Siliciumdioxidanteil an der Summe der Glasbildner soll 0,8 bis 1 betragen.

Titandioxid dient in diesem Glas der Erhöhung des Brechwertes und der Dispersion. Sein Gehalt soll 5 bis 25 Gew.-%, bevorzugt 7 bis 23 Gew.-% und am meisten bevorzugt 9 bis 20 Gew.-% betragen. Zur Justierung der optischen Lage wird ferner Zirkonoxid in Mengen von 0 bis 5, bevorzugt 0 bis 3 Gew.-% eingesetzt. Werden diese Werte unterschritten, kann die gewünschte optische Lage nicht erreicht werden. Werden die Werte jedoch überschritten, steigt die Kristallisationstendenz der Gläser. Die Summe dieser beiden Komponenten soll von 5 bis 25 Gew.-%, bevorzugt 7 bis 22 Gew.-% und am meisten bevorzugt 10 bis 20 Gew.-% betragen. Idealerweise soll die Summe von Titanoxid, Zirkonoxid und der Glasbildner zusammen 70 bis 85 Gew.-%, weiter bevorzugt 73 bis 83 Gew.-% und am meisten bevorzugt wenigstens 75 Gew.-% betragen.

Es ist bevorzugt, dass die Titan-Silikate, die erfindungsgemäß verwendet werden können, Lithiumoxid in Gehalten von 0 bis 5 Gew.-%, bevorzugt 0 bis 3 Gew.-% aufweisen. Diese Komponente wird zur Feineinstellung der Viskosität verwendet. In Kombination mit Boroxid kann diese Komponente die Herstellungsanlagen stark angreifen, was zu Trübung, heterogener Keimung und geringen Standzeiten der Aggregate führt. Ferner führt Lithiumoxid zu erhöhter lonenmobilität, was wiederum Kristallisation nach sich ziehen kann. Außerdem wird die chemische Resistenz des Glases verringert. Daher sind bevorzugte Ausführungsformen frei von Lithiumoxid.

Die erfindungsgemäß eingesetzten Titansilikate können Kaliumoxid umfassen. Kaliumoxid dient der Einstellung der Abhängigkeit der Viskosität von Temperaturänderungen. Es ist bevorzugt in Mengen von 0 bis 25 Gew.-%, weiter bevorzugt 3 bis 23 Gew.-% im Glas enthalten. Ähnlich wie bei Lithiumoxid führt ein zu großer Anteil am Glas zu erhöhter lonenmobilität und geringer chemische Resistenz. Wird ein zu kleiner Anteil gewählt, ist die Viskosität des Glases zu hoch.

Die erfindungsgemäß eingesetzten Titan-Silikate können Natriumoxid umfassen. Natriumoxid dient der Einstellung des Temperatur-Viskositätsprofils. Es ist bevorzugt in Mengen von 0 bis 15 Gew.-% im Glas enthalten. Ähnlich wie Lithiumoxid führt es bei zu großem Anteil am Glas zu erhöhter lonenmobilität und geringer chemischer Resistenz. Bevorzugte Ausführungsformen sind frei von Lithiumoxid.

Aus den vorhergehenden Absätzen wird deutlich, dass der Gehalt an Alkalioxiden im erfindungsgemäßen Titansilikatglas begrenzt werden muss, um die Viskosität und die Abhängigkeit der Viskosität von der Temperatur einzustellen. Aus diesem Grund ist der Anteil an den Alkalioxiden Lithiumoxid, Natriumoxid und Kaliumoxid bevorzugt auf einen Gehalt von 15 bis 25 Gew.-%, weiter bevorzugt 17 bis 25 Gew.-% und am meisten bevorzugt 18 bis 22 begrenzt. In bevorzugten Ausführungsformen enthält dieses Glas mit Ausnahme von Kaliumoxid keine Alkalioxide.

Um die Länge des Glases optimal einzustellen, soll der Anteil der Summe der Erdalkalioxide Magnesiumoxid, Calciumoxid, Strontiumoxid und Bariumoxid vorzugsweise einen Wert von 0 bis 5 Gew.-% annehmen, weiter bevorzugt sind 0 bis 3 Gew.-%, am meisten bevorzugt ist das Glas frei von Erdalkalioxiden.

Ein besonders bevorzugtes Titan-Silikatglas hat folgende Zusammensetzung in Gew.-%

| | |
|---|---|
| SiO₂ | 50 bis 75 |
| B₂O₃ | 0 bis 10 |
| Al₂O₃ | 0 bis 10 |
| B₂O₃+Al₂O₃ | 0 bis 15 |
| SiO₂+B₂O₃+Al₂O₃ | 50 bis 75 |
| SiO₂/ (SiO₂+B₂O₃+Al₂O₃) | 0,8 bis 1 |
| TiO₂ | 5 bis 25 |
| ZrO₂ | 0 bis 5 |
| TiO₂ + ZrO₂ | 5 bis 25 |
| GB + TiO₂ + ZrO₂ | 70 bis 85 |
| Li₂O | 0 bis 5 |
| Na₂O | 0 bis 15 |
| K₂O | 0 bis 25 |
| Li₂O+Na₂O+K₂O | 15 bis 25 |
| MgO+CaO+SrO+BaO | 0 bis 5 |

In weiter bevorzugten Ausführungsformen hat das Titan-Silikatglas folgende Zusammensetzung in Gew.-%:

| | |
|---|---|
| SiO2 | 50 bis 70 |
| B2O3 | 0 bis 8 |
| Al2O3 | 0 bis 9 |
| B2O3+Al2O3 | 0 bis 15 |
| SiO2+B2O3+Al2O3 | 52 bis 73 |
| SiO2 / (SiO2+B2O3+AI2O3) | 0,8 bis 1 |
| TiO2 | 7 bis 22 |
| ZrO2 | 0 bis 3 |
| TiO2 + ZrO2 | 7 bis 22 |
| GB + TiO2 + ZrO2 | 73 bis 83 |
| Li2O | 0 bis 3 |
| Na2O | 0 bis 15 |
| K2O | 3 bis 23 |
| Li2O+Na2O+K2O | 17 bis 25 |
| MgO+CaO+SrO+BaO | 0 bis 3 |

### Erdalkali-Titansilikatgläser

In einer anderen bevorzugten Ausführungsform ist das erfindungsgemäß verwendete Glas ein Silikatglas vom Typ Erdalkali-Titan-Silikatglas.

In den Erdalkali-Titansilikatgläsern wird Siliciumdioxid als Hauptglasbildner in Gehalten von 20 bis 50 Gew.-%, weiter bevorzugt 25 bis 50 Gew.-%, am meisten bevorzugt bis 47 Gew.-% verwendet. Diese Komponente erhöht die chemische Resistenz und Härte des Glases. Wird sie jedoch in zu hohen Mengen eingesetzt, werden die hohen Brechwerte nicht erreicht und hohe Einschmelztemperaturen erschweren den Herstellungsprozess.

Als weiterer Glasbildner wird Boroxid verwendet, das auch die Einschmelztemperaturen verringert. Es wird vorzugsweise in Mengenanteilen von 0 bis 10 Gew.-%, weiter bevorzugt in Anteilen von 0 bis 8 Gew.-% eingesetzt, in besonders bevorzugten Ausführungsformen wird es in Mengen von bis zu 7 Gew.-% verwendet. Ist der Anteil an Boroxid im bevorzugten Glas zu gering, wird die Viskosität des Glases zu hoch. Wird hingegen eine zu große Menge an Boroxid verwendet, werden die erwünschten hohen Brechwerte nicht erreicht. Außerdem wird durch einen hohen Boroxidanteil die lonenmobilität im Glas erhöht, wodurch wiederum die Kristallisationsneigung steigt. Ferner erhöhen hohe Boroxidanteile im Glas den Eintrag des Feuerfestmaterials während der Herstellung in das Glas. Dies führt zu Inhomogenität, Streuung, heterogenen Keimen und wiederum Kristallisation.

Aluminiumoxid erhöht ebenfalls die chemische Resistenz des Glases. Es ist in den erfindungsgemäß eingesetzten Erdalkali-Titansilikatgläsern in Mengen von vorzugsweise bis zu 5 Gew.-%, weiter bevorzugt ist zu 3 Gew.-% enthalten. Wird dieser Anteil jedoch überschritten, so erhöhen sich die Einschmelztemperaturen des Glases, was zu erhöhtem Energieverbrauch und verringerten Aggregatsstandzeiten führt. Ferner wird dadurch ein unerwünscht langes Glas erhalten. In Ausführungsformen der Erfindung ist das Erdalkali-Titansilikatglas daher frei von Aluminiumoxid.

Zur Ausbildung der Glasmatrix dienen unter anderem Aluminiumoxid und Boroxid; es ist vorteilhaft, wenn der Gehalt dieser Komponenten so gewählt wird, dass die Summe von Aluminiumoxid und Boroxid in einem Wertebereich von 0 bis 10 Gew.-% angesiedelt ist. Weiter bevorzugt ist eine Summe in einem Bereich von 0 bis 8 Gew.-%, am meisten bevorzugt sind bis zu 7 Gew.-%. Wird dieser Gehalt zu groß gewählt, neigt das Glas zu Kristallisation.

Die Summe von Siliciumdioxid, Boroxid und Aluminiumoxid (=Summe der Glasbildner) soll in einem Bereich von 20 bis 55 Gew.-%, bevorzugt 25 bis 55 Gew.-% liegen, am meisten bevorzugt sind bis zu 30 Gew.-%. Das Verhältnis von Siliciumdioxid zur Summe der Glasbildner soll 0,8 bis 1 betragen. Dadurch wird ein Glas mit der erforderlichen Resistenz erhalten.

Es ist bevorzugt, dass die Erdalkali-Titansilikate, die erfindungsgemäß verwendet werden können, Lithiumoxid in Gehalten von 0 bis 5 Gew.-%, bevorzugt 0 bis 2 Gew.-% aufweisen. Diese Komponente wird zur Feineinstellung der Viskosität verwendet. In Kombination mit Boroxid kann sie die Herstellungsanlagen stark angreifen, was zu Trübung, heterogener Keimung und geringen Standzeiten der Aggregate führt. Ferner führt Lithiumoxid zu erhöhter lonenmobilität, was wiederum Kristallisation nach sich ziehen kann. Außerdem wird die chemische Resistenz des Glases verringert. Daher sind bevorzugte Ausführungsformen frei von Lithiumoxid.

Die erfindungsgemäß eingesetzten Erdalkali-Titansilikate können Kaliumoxid umfassen. Kaliumoxid dient der Feineinstellung der Viskosität. Es ist bevorzugt in Mengen von 0 bis 10 Gew.-%, weiter bevorzugt 0,5 bis 8 Gew.-% im Glas enthalten. Ähnlich wie bei Lithiumoxid führt ein zu großer Anteil am Glas zu erhöhter lonenmobilität und geringer chemische Resistenz.

Die erfindungsgemäß eingesetzten Erdalkali-Titansilikate können Natriumoxid umfassen. Natriumoxid dient der Feineinstellung der Viskosität. Es ist bevorzugt in Mengen von 0 bis 15 Gew.-%, weiter bevorzugt 3 bis 13 Gew.-% im Glas enthalten. Ähnlich wie Lithiumoxid führt ein zu großer Anteil am Glas zu erhöhter Ionenmobilität und geringer chemische Resistenz. Daher sind bevorzugte Ausführungsformen sogar frei von Natriumoxid.

Aus den vorhergehenden Absätzen wird deutlich, dass der Gehalt an Alkalioxiden im erfindungsgemäßen Erdalkali-Titansilikatglas begrenzt werden muss, um Feineinstellungen an der Viskosität vorzunehmen. Aus diesem Grund ist der Anteil an den Alkalioxiden Lithiumoxid, Natriumoxid und Kaliumoxid bevorzugt auf einen Gehalt von 8 bis 25 Gew.-%, weiter bevorzugt 10 bis 22 Gew.-% begrenzt. In bevorzugten Ausführungsformen ist ihr Gehalt wenigstens 13 Gew.-%. Vorzugsweise enthält dieses Glas neben Kaliumoxid keine Alkalioxide.

Ausführungsformen der Erdalkali-Titansilikate weisen Magnesiumoxid auf. Bevorzugt liegt dessen Gehalt bei bis zu 5 Gew.-%, weiter bevorzugt bis zu 3 Gew.-%. Magnesiumoxid wird eingesetzt, um die Viskosität des Glases einzustellen. Wird zu viel Magnesiumoxid eingesetzt, erhöht dies die Kristallisationsneigung der Gläser. Deshalb sind bevorzugte Ausführungsformen frei von Magnesiumoxid.

Die Erdalkali-Titansilikate können Strontiumoxid umfassen. Dieses liegt dann in Mengen von bis zu 5 Gew.-% vor, bevorzugte Ausführungsformen weisen höchstens 3 Gew.-% auf, um die Viskosität des Glases einzustellen. Wird zu viel Strontiumoxid eingesetzt, werden zu kurze Gläser erhalten.

Die Erdalkali-Titansilikate können Calciumoxid enthalten, um die Abhängigkeit der Viskosität von der Temperatur einzustellen. Zu diesem Zweck wird Calciumoxid in Mengen von bis zu 5 Gew.-% eingesetzt, bevorzugte Ausführungsformen weisen bis zu 3 Gew.-% auf. Wird zu viel Calciumoxid eingesetzt, wird ein zu kurzes Glas erhalten.

Die Erdalkali-Titansilikate können auch Bariumoxid umfassen. Bariumoxid erhöht den Brechwert der Gläser und dient der Einstellung der Abhängigkeit der Viskosität von der Temperatur. Zu diesem Zweck wird Bariumoxid in Mengen von 4 bis 20 Gew.-%, bevorzugt 4 bis 18 Gew.-% eingesetzt. Wird indes zu viel Bariumoxid verwendet, wird ein zu kurzes Glas erhalten. Wird zu wenig verwendet, ist der Brechwert der so erhaltenen Gläser zu gering, das Glas zu lang.

Um die Länge des Glases optimal einzustellen, soll der Anteil der Summe der oben beschriebenen Erdalkalioxide vorzugsweise einen Wert von 4 bis 25 Gew.-% annehmen.

Um die optische Lage des Erdalkali-Titansilikatglases einzustellen, werden Titanoxid und Zirkonoxid verwendet. Dabei liegt deren Gehalt in Summe bei 15 bis 35 Gew.-%. In bevorzugten Ausführungsformen liegt ihr Gehalt bei 18 bis 32 Gew.-%. Dabei liegt der Gehalt an Titanoxid bei vorzugsweise 12 bis 35 Gew.-%, weiter bevorzugt 15 bis 30 Gew.-%; der von Zirkonoxid bevorzugt bei 0 bis 8 Gew.-%, weiter bevorzugt 0 bis 5 Gew.-%. Werden diese Komponenten in zu großer Menge eingesetzt, erhöht sich die Kristallisationsneigung der Gläser. Um dem vorzubeugen, soll die Summe der Anteile von Titandioxid, Zirkonoxid und der Glasbildner Werte von 50 bis 80 Gew.-%, bevorzugt 52 bis 77 Gew.-% annehmen.

Vorzugsweise liegt der Anteil der Summe von Titanoxid, Zirkonoxid, der Erdalkalioxide und der Glasbildner zusammen bei 65 bis 92 Gew.-%, mehr bevorzugt 65 bis 88 Gew.-%. In anderen Ausführungsformen liegt dieser Anteil bei wenigstens 68 Gew.-%, mehr bevorzugt wenigstens 70 Gew.-% und am meisten bevorzugt wenigstens 85 Gew.-%. Es hat sich gezeigt, dass dadurch eine geeignete Glasmatrix für die erfindungsgemäße Verwendung bereitgestellt werden kann.

Die erfindungsgemäßen Gläser können Yttriumoxid, Ytterbiumoxid, Gadoliniumoxid, Nioboxid und Tantaloxid in Anteilen von zusammen 0 bis 20 Gew.-%, bevorzugt 0 bis 15 Gew.-%, weiter bevorzugt 0 bis 12 Gew.-% und am meisten bevorzugt 0 bis 10 Gew.-% aufweisen. Die in diesem Absatz genannten Komponenten dienen der Einstellung der erfindungsgemäß benötigten optischen Lage. Es ist allerdings zu berücksichtigen, dass die Mengen, in denen diese Komponenten eingesetzt werden, begrenzt werden müssen, weil ansonsten eine verringerte Transmission aufgrund einer Verschiebung der UV-Kante zu befürchten ist. Ferner führen zu große Mengen zu Kristallwachstum. Dabei sind bevorzugte Ausführungsformen gänzlich frei von Nioboxid, weil dieses im Floatprozess reduziert werden kann.

Besonders bevorzugte Erdalkali-Titansilikatgläser haben folgende Zusammensetzung in Gew.-%:

| | |
|---|---|
| SiO₂ | 20 bis 50 |
| B₂O₃ | 0 bis 10 |
| Al₂O₃ | 0 bis 5 |
| B₂O₃+Al₂O₃ | 0 bis 10 |
| SiO₂+B₂O₃+Al₂O₃ | 20 bis 55 |
| SiO₂/(SiO₂+B₂O₃+Al₂O₃) | 0,8 bis 1 |
| TiO₂ | 12 bis 35 |
| ZrO₂ | 0 bis 8 |
| TiO₂ + ZrO₂ | 15 bis 35 |
| SiO₂ + B₂O₃+Al₂O₃ + TiO₂ + ZrO₂ | 50 bis 80 |
| Li₂O | 0 bis 5 |
| Na₂O | 0 bis 15 |
| K₂O | 0 bis 10 |
| Li₂O+Na₂O+K₂O | 8 bis 25 |
| MgO | 0 bis 5 |
| CaO | 0 bis 5 |
| SrO | 0 bis 5 |
| BaO | 4 bis 20 |
| MgO+CaO+SrO+BaO | 4 bis 25 |
| SiO₂+B₂O₃+Al₂O₃+MgO+CaO+SrO+BaO+TiO₂ + ZrO₂ | 65 bis 92 |
| Y₂O₃+Yb₂O₃+Gd₂O₃+Ta₂O₅+Nb₂O₅ | 0 bis 20 |

In weiter bevorzugten Ausführungsformen hat Erdalkali-Titansilikatglas Zusammensetzung in Gew.-%:

| | |
|---|---|
| SiO₂ | 25 bis 50 |
| B₂O₃ | 0 bis 8 |
| Al₂O₃ | 0 bis 3 |
| B₂O₃+Al₂O₃ | 0 bis 8 |
| SiO₂+B₂O₃+Al₂O₃ | 25 bis 55 |
| SiO₂/ (SiO₂+B₂O₃+Al₂O₃) | 0,8 bis 1 |
| TiO₂ | 15 bis 30 |
| ZrO₂ | 0 bis 5 |
| TiO₂ + ZrO₂ | 18 bis 32 |
| SiO₂+B₂O₃+Al₂O₃+TiO₂+ZrO₂ | 52 bis 77 |
| Li₂O | 0 bis 2 |
| Na₂O | 3 bis 13 |
| K₂O | 0,5 bis 8 |
| Li₂O+Na₂O+K₂O | 10 bis 22 |
| MgO | 0 bis 3 |
| CaO | 0 bis 3 |
| SrO | 0 bis 3 |
| BaO | 4 bis 18 |
| MgO+CaO+SrO+BaO | 4 bis 25 |
| SiO₂+B₂O₃+Al₂O₃+MgO+CaO+SrO+BaO+TiO₂+ZrO₂ | 65 bis 88 |
| Y₂O₃+Yb₂O₃+Gd₂O₃+Ta₂O₅+Nb₂O₅ | 0 bis 15 |

Durch unterschiedliche Verhältnisse zwischen den Komponenten der Grundglasmatrizes und der ergänzend beigefügten hochbrechenden Komponenten können in allen drei Glasfamilien Gläser mit Brechungsindizes eines weiten Bereiches eingestellt werden. So umspannen die erreichbaren Bereiche der Glasfamilien Brechungsindizes zwischen >1,6 und 1,85. Bevorzugt weisen die Gläser Brechwerte von n_{d} > 1,6, weiter bevorzugt n_{d} > 1,7 und am meisten bevorzugt n_{d} > 1,8 auf. Dabei repräsentieren die Lanthanborate optische Bereiche geringerer Dispersion, während die Titansilikate äußerst hohe Dispersionen aufweisen. Gläser mit Borosilikatmatrix liegen hier im moderaten Mittel.

Alle diese Gläser sind aufgrund der angestrebten Eignung für Flachglas-, speziell Floatglasprozesse, bis auf unvermeidliche Verunreinigungen vorzugsweise frei von stark redox-aktiven polyvalenten Komponenten wie den Oxiden von Blei, Arsen und Antimon. Diese Komponenten würden im Flachglasprozess andernfalls zu Verfärbungen im Glas führen, was dem erfindungsgemäßen Ziel höherer Effizienz hinsichtlich der Lichtausbeute zuwiderlaufen würde. Hierdurch werden die zugelassenen Läutermittel auf diejenigen der physikalischen Läuterunterstützung beschränkt. Daher werden als Läutermittel vorzugsweise F, SnO, NaCl in Mengen von bis zu 1 Gew.-% eingesetzt. Weniger bevorzugte Ausführungsformen für nichtfloat Flachglasprozesse, wie z.B. den Ziehprozess, das DownDraw-Verfahren oder auch Overflow Fusion-Prozesse, dürfen dagegen die für den Läuterprozess notwendigen gängigen Redox-Läutermittel Arsenoxid und Antimonoxid in üblichen Mengen (bis 1 Gew.-%) enthalten.

Aus demselben Grund weisen die opto-technischen Hybridgläser bis auf unvermeidbare Verunreinigungen vorzugsweise auch nicht die schwächer redox-aktiven Oxide von Niob und Wolfram auf. Es ist am meisten bevorzugt, dass die opto-technischen Hybridgläsern frei sind von redox-aktiven Komponenten.

Es ist erfindungsgemäß bevorzugt, dass die Hybridgläser bis auf unvermeidbare Verunreinigungen frei sind von Zinkoxid. Weiterhin ist es bevorzugt, dass die Hybridgläser bis auf unvermeidbare Verunreinigungen frei sind von Bismuthoxid.

Die erfindungsgemäßen Gläser sind somit ökologisch unbedenkliche optische Gläser für die Applikationsbereiche Beleuchtung und Display.

Für den Floatprozess dagegen weiter bevorzugte Ausführungsformen sind zusätzlich bis auf unvermeidliche Verunreinigungen frei von schwächer redox-aktiven Komponenten, also den Oxiden von Wolfram und Niob. Für Niob gilt dies jedoch nicht in den Gläsern der Lanthanboratfamilie, da in dieser Matrix das Nioboxid ein deutlich verringertes Redoxpotential besitzt und bis zu einem Gehalt von 20 Gew.-% eingesetzt werden kann. Der Einsatz dieser Komponenten führt durch Redoxreaktionen mit dem Zinn-Floatbad zur Entstehung farbiger Komponenten, die dem Sinn der hohen Transmission bereits des Bulkglases entgegenstehen.

Vergleichbar wird Bismuthoxid zu elementaren Bismuth reduziert, welches transmissionsmindernde Streueffekte hervorruft und zusätzlich als Kristallisationskeim dienen kann. Weiter bevorzugte Ausführungsformen sind daher bis auf unvermeidliche Verunreinigungen frei von Bismuthoxid.

Ebenso im Hinblick auf den Floatprozess bevorzugte Ausführungsformen sind bis auf unvermeidliche Verunreinigungen frei von Zinkoxid, welches im Kontakt mit dem Floatbad zu Oberflächenkristallisation in der Heißformgebung führt.

Erfindungsgemäß wird aus den oben beschriebenen Gläsern ein Flachglas hergestellt, das als Substrat für den Schichtverbund dienen kann. Das heißt, dass es als Grundlage für den Aufbau des transparenten Schichtverbundes dient. Dabei ist es vorteilhaft, dass das Glas hohe Temperaturen unbeschadet überstehen kann. Die Verarbeitungstemperatur des leitfähigen transparenten Oxids wird üblicherweise so hoch sein, dass sich der organische Halbleiter zersetzen würde. Daher wird im Herstellungsprozess des Schichtverbundes zunächst eine Schicht des transparenten Oxides auf das Substrat aufgebracht und erst danach der organische Halbleiter aufgetragen.

Die erfindungsgemäßen Gläser werden optional chemisch vorgespannt, um Brüchen bei mechanischer Beanspruchung vorzubeugen. Zu diesem Zweck ist es bevorzugt, dass alle Gläser Aluminiumoxid enthalten. Aluminiumoxid verändert die Netzwerkstruktur positiv in Richtung erhöhter lonenmobilität (für den Austausch), ohne aber (wie jedoch die Alkalioxide und Boroxid) dabei die Kristallisationsneigung signifikant zu erhöhen.

Die transparente Oxidschicht im transparenten Schichtverbund der vorliegenden Erfindung ist erfindungsgemäß leitfähig und umfasst vorzugsweise ITO. ITO hat sich als Werkstoff für transparente Oxidschichten bewährt. Auch erfindungsgemäß ist die Verwendung niedermolekularer Schichten von Graphen, einem hochleitfähigen, transparenten Werkstoff.

Erfindungsgemäß ist der Brechwert des opto-technischen Hybridglases an den Brechwert der Oxidschicht angepasst. Dabei ist der Brechwertunterschied zwischen den beiden Schichten vorzugsweise höchstens 0,5, weiter bevorzugt höchstens 0,4 und besonders bevorzugt höchstens 0,3. Diese Ausführungsform ist deshalb bevorzugt, weil die transparente Oxidschicht üblicherweise diejenige Schicht im transparenten Schichtverbund ist, welche der Substratsschicht in Austrittsrichtung des emittierten Lichtes folgt. Damit ist das Substrat ein sogenanntes "Superstrat".

Die Halbleiterschicht im transparenten Schichtverbund dieser Erfindung umfasst vorzugsweise einen organischen Halbleiter. Diese lassen sich über ihre Molekularmassen in konjugierte Moleküle und konjugierte Polymere einteilen. So klassifizieren sich Organische LEDs auf Basis konjugierter Moleküle (SOLED oder SMOLED) und auf Basis konjugierter Polymere (PLEDS). Der erfindungsgemäß verwendete organische Halbleiter ist bevorzugt ausgewählt aus der Gruppe der konjugierten Polymere, bestehend aus heterozyklischen Polymeren, insbesondere Polythiophenen, Polyparaphenylen, Polypyrrol, Polyanilin, und Kohlenwasserstoffketten, insbesondere Polyacetylen, Polysulfumitriden, jeweils auch substituiert möglich. Als Farbstoffe können erfindungsgemäß Derivate von Poly(p-Phenylen-Vinylen) (PPV) oder bei effizienteren Neuentwicklungen metall-organische Komplexe eingesetzt werden (Triplett-Emitter). In alternativen Ausführungsformen ist der Halbleiter nicht transparent.

Eine unter Verwendung des Schichtverbundes hergestellte Leuchtdiode oder ein entsprechendes Solarmodul weist neben der Halbleiterschicht, der transparenten Oxidschicht und der Substratschicht, also dem Schichtverbund der vorliegenden Erfindung, eine Kathodenschicht auf, die eine metallische oder legierte Kathode umfasst. Die metallischen Kathoden sind vorzugsweise ausgewählt aus der Gruppe bestehend aus Calcium, Aluminium, Barium, Ruthenium, während die legierten Kathoden vorzugsweise aus folgender Gruppe ausgewählt sind: Magnesium-Silber-Legierung und Legierungen aus den Komponenten metallischer Kathoden.

Erfindungsgemäß ist auch die Verwendung des transparenten Schichtverbundes als Bestandteil einer Leuchtdiode, vorzugsweise OLED, weiter bevorzugt PLED.

Erfindungsgemäß ist auch ein Verfahren zur Herstellung eines transparenten Schichtverbundes gemäß dieser Erfindung, welches die folgenden Schritte umfasst:
Herstellung des Substrates in einem Flachglasprozess
Zusammenfügen des Substrates mit anderen Schichten zu einem Schichtverbund.

Die Herstellung des Substrates in einem Flachglasprozess erfolgt vorzugsweise in einem kontinuierlichen Schmelzprozess: das entsprechend der Synthesevorschrift vorbereitete Gemenge wird batchweise (portionsweise) einer herkömmlichen Schmelzwanne zugeführt und dort im Einschmelzbereich erhitzt, bis ein Schmelzfluss ausreichend geringer Viskosität für den weiteren Prozess erreicht ist. Üblicherweise wird dies bei Temperaturen, die über die Temperatur-Viskositätskurve des jeweils aufliegenden Glastyps mit Viskositäten unter 10³ dPas korrelieren erreicht.

Im weiteren Durchgang durch das Aggregat wird vorzugsweise bei diesen Viskositäten die Ausbildung von Konvektionswalzen zur Homogenisierung des Rohschmelzflusses erreicht. Die Homogenisierung kann jedoch auch durch das Einblasen inerter oder redox-stabilisierender Gase (Stickstoff, Helium oder Sauerstoff) oder durch mechanisches Rühren erfolgen. Bei weiter erniedrigten Viskositäten (etwa ab 10^{2,5} dPas) kann der Läuterprozess einsetzten, der entweder über chemische oder physikalische Läuterprozesse die Rohschmelze von der beim Einschmelzen erzeugten Gaslast befreit und blasenfreies Glas entstehen lässt. Dieser geläuterte und homogenisierte Glasfluss wird dann vorzugsweise etwa bei Viskositäten um VA (10⁴ dPas) einem der verschiedenen möglichen HFG-Verfahren (Ziehen, Walzen, Floaten, DownDraw, OverflowFusion) zugeführt. Dabei muss beachtet werden, dass sich bei dem angestrebten Floatprozess der Einsatz einer klassischen Redox-Läuterung verbietet. Das entstehende kontinuierliche Glasband gewünschter Breite und Dicke wird vorzugsweise nach Durchlaufen einer Kühlstrecke zur Verhinderung von Spannungsbrüchen auf die gewünschte Länge der Platten/Scheiben vereinzelt.

Der Floatprozess ermöglicht es, die Substrate für erfindungsgemäße Schichtverbunde wirtschaftlich und in den erforderlichen Maßen herzustellen. Dabei wirken sich im Floatverfahren zwei Aspekte besonders positiv aus: der totecken-freie Aufbau des HFG-Teils einer Floatwanne führt dazu, dass deutlich geringere Anforderungen an die Entglasungsstabilität des Materials gestellt werden müssen und so eine erweiterte Zahl Glastypen, in diesem Fall die im Vergleich mit standard-technischen Gläsern kristallisationsanfälligeren hochbrechenden Hybridgläser, dem Flachglasverfahren zugänglich werden. "Totecken-frei" bedeutet in diesem Fall, dass keine Teilportionen des Schmelzflusses in geometrisch wenig durchflossenen Winkeln (Totvolumen, bzw. -ecken) signifikant länger bei HFG-Viskositäten verweilen, in denen vermehrt Keimbildung und Kristallwachstum stattfinden können.

Zweiter besonders positiver Aspekt des Floatens ist die Schwerkraft-unbeeinflusste Auflage des Glasbandes auf dem Zinnbad, die ungewünschte Verformungen nach der Düse (natürlich nicht das gewünschte, gezielte Breitlaufen des Glasbandes), besonders Verwellungen u.ä., verhindert. So kann die effektive Ausbeute durch Verminderung von geometrischem Ausschuss deutlich gegenüber Zieh- und Walzprozessen ohne frühe, klebefreie Auflage erhöht werden.

Basierend auf der hier vorgestellten neuen Klasse Hybridgläser wurde durch die Brechwertanpassung an die transparente Oxidschicht, hier bevorzugt die ITO-Schicht, ein hochtransmissiver Materialverbund geschaffen, der durch erhöhte Lichtausbeute zur Effizienzsteigerung von organischen Leuchtdioden und damit zu einer optimierten Generation OLEDs und Solarmodulen beiträgt.

Durch die erfindungsgemäßen Hybridgläser wurde eine derartige Einstellung von Kristallisationsstabilität und Viskositätstemperaturprofil neben einer ausreichenden Redoxstabilität realisiert, dass die Herstellung dieser für einen hochtransparenten Schichtverbund notwendig hoch-brechenden optischen Gläser in einem Flachglasprozess, hier insbesondere dem Floatprozess, ermöglicht wird.

Die erfindungsgemäßen hochbrechenden Gläser sind somit geeignet, in ihrer durch Produktion in einem Flachglasprozess, bevorzugt in einem Floatglasprozess, gewonnenen Geometrie als flaches, dünnes Superstrat eingesetzt zu werden, um durch Abscheiden transparenter, leitfähiger Oxidschichten hierauf, insbesondere ITO-Schichten, alternativ nicht-oxidische Graphen-Schichten, einen hochtransparenten Schichtverbund zur Herstellung von Effizienz-optimierten OLEDs zu erzeugen. Die Schichtdicke des Substrates ist dabei kleiner als 2 mm, bevorzugt kleiner als 1,5 mm, weiter bevorzugt liegt sie im Bereich von 0,7 bis 1,1 mm.

Wenn in dieser Beschreibung nichts anderes erwähnt ist, bedeuten Formulierungen wie "frei von", "nicht enthalten" und ähnliche jeweils dass die entsprechende Komponente nicht zielgerichtet zum Glas hinzugefügt wurde; es ist damit gemeint, dass die genannte Komponente allenfalls als Verunreinigung im Glas enthalten ist.

In bevorzugten Ausführungsformen bestehen die beschriebenen Gläser zu wenigstens 90 Gew.-%, weiter bevorzugt 95 Gew.-% und am meisten bevorzugt 98 Gew.-% aus den Komponenten, die hierin als Bestandteile der entsprechenden Gläser genannt sind.

### Ausführungsbeispiele

Die Tabellen 2-6 enthalten 45 Ausführungsbeispiele in den bevorzugten Zusammensetzungsbereichen. Die erfindungsgemäßen Gläser werden folgendermaßen hergestellt:
Aufgrund der kosten- und kapazitätsintensiven Gestaltung eines Glaswechsels in einem üblichen Flachglasaggregat wurden nur einzelne der Ausführungsbeispiele in einem großvolumigen Flachglasaggregat gefertigt. Stattdessen wurden die Ausführungsbeispiele im Laborvolumen in Platin1Iridium- und Kieselglas-Tiegeln erschmolzen und anschließend materialspezifische Parameter erfasst, die Aufschluss über die Produzierbarkeit in einem Flachglasprozess geben.

Neben der Viskositäts-Temperaturkurve wurde die Obere Entglasungsgrenze (OEG, Trägerblechmethode, aufsteigende Temperaturführung) erfasst und das Redox-Verhalten in Bezug auf elementares Zinn elektrochemisch charakterisiert. Die erfindungsgemäßen Gläser zeigen somit OEGs bei Temperaturen, die mindestens 20K, bevorzugt 50K, weiter bevorzugt 100K unterhalb der HFG-Temperaturen liegen, also bei Viskositäten oberhalb der jeweiligen, prozessspezifischen HFG-Viskosität. Dabei zeigen die für einen Floatprozess bevorzugten erfindungsgemäßen Gläser (bis auf unvermeidliche Verunreinigungen frei von polyvalenten Verbindungen und Zinkoxid) in der elektrochemischen Charakterisierung keine Anzeichen für eine redox-sensitive Reaktion mit dem Zinnbad.

Für die Produktion in einem üblichen Flachglasaggregat werden die Rohstoffe für die Oxide, bevorzugt die Oxide selbst und/oder Carbonate und/oder Fluoride abgewogen, ein oder mehrere prozessangepassten Läutermittel zugegeben und anschließend gut gemischt. Das Glasgemenge wird Glastyp-abhängig bei Temperaturen, die Viskositäten von etwa 10³ dPas entsprechen in einem kontinuierlichen Schmelzaggregat eingeschmolzen und häufig über die Einstellung von Konvektionswalzen homogenisiert, danach bei Temperaturen, die Viskositäten von etwa 10^{2,5} dPas entsprechen, geläutert und abschließend homogenisiert. Bei einer abgesenkten Flusstemperatur, die Viskositäten von etwa 10⁴ dPas (Verarbeitungstemperatur VA) entspricht, wird das Glas dem jeweiligen HFG-Prozess zugeführt und zu den gewünschten Abmessungen verarbeitet.

### Schmelzbeispiel für 100 kg berechnetes Glas (Tabelle 1)

| **Oxid** | **Gew.-%** | **Rohstoff** | **Einwaage (kg)** |
|---|---|---|---|
| SiO₂ | 45 | SiO₂ | 44,97 |
| Li₂O | 2 | Li₂CO₃ | 4,96 |
| Na₂O | 3 | Na₂CO₃ | 5,12 |
| K₂O | 10 | K₂CO₃ | 14,70 |
| MgO | 5 | MgCO₃ | 11,58 |
| BaO | 18 | BaCO₃ | 23,12 |
| TiO₂ | 15 | TiO₂ | 15,06 |
| ZrO₂ | 2 | ZrO₂ | 1,99 |
| NaCl | 0,2 | NaCl | 0,19 |
| Summe | 100,2 | | 121,69 |

Die Eigenschaften des so erhaltenen Glases sind in der Tabelle 6, Beispiel 36 angegeben.

**Tabelle 2 Schmelzbeispiele Lanthanborate (in Gew. %)**

| Beispiel | 1 | 2 | 3 | 4 | 5 | 6 | 8 | 9 |
|---|---|---|---|---|---|---|---|---|
| SiO₂ | 7 | 4 | 0,5 | 4 | 1 | 11 | 10 | 8 |
| B₂O₃ | 41 | 34 | 32 | 38 | 17 | 7 | 14 | 10 |
| Al₂O₃ | | 1 | | | | | | |
| Li₂O | | | | 1 | | | | |
| Na₂O | | | | | | | | 1 |
| K20 | | | 1,5 | | | | | |
| MgO | | | 2 | | | | 5 | |
| CaO | 10 | | | 5 | | | 10 | 5 |
| BaO | | 8 | | | | | | |
| SrO | | 2 | | 1 | | | | |
| TiO₂ | | | | 2 | | | 9 | |
| ZrO₂ | 3 | 5 | 4 | 5 | 9 | 8 | 7 | 5 |
| La₂O₃ | 39 | 41 | 45 | 42 | 50 | 47 | 25 | 40 |
| Y₂O₃ | | 2 | 8 | | | | | 4 |
| Yb₂O₃ | | | | | | 5 | | |
| Gd₂O₃ | | | 7 | | | 10 | | 9 |
| Ta₂O₅ | | 2 | | | 8 | 12 | | 16 |
| Nb₂O₅ | | | | 2 | 15 | | 20 | 2 |
| Summe | 100 | 100 | 100 | 100 | 100 | 100 | 100 | 100 |
| | | | | | | | | |
| nd | 1,70 | 1,74 | 1,75 | 1,74 | 1,88 | 1,88 | 1,89 | 1,88 |
| vd | 55 | 52 | 53 | 51 | 38 | 41 | 31 | 41 |
| Tg[°C] | 662 | 639 | 641 | 637 | 680 | 719 | 649 | 700 |
| CTE_{20/300} [ppm/K] | 7,0 | 6,7 | 6,8 | 6,8 | 7,3 | 7,7 | 8,3 | 8,6 |
| spez. Dichte [g/cm³] | 3,6 | 4,0 | 4,1 | 4,1 | 4,8 | 5,5 | 4,0 | 5,4 |
| τ_{i 2mm 420nm} [%] | 99,8 | 99,8 | 99,7 | 99,8 | 99,4 | 99,2 | 98,8 | 99,4 |

**Tabelle 3 Schmelzbeispiele Erdalkali-Borosilikate (in Gew. %)**

| Beispiel | 10 | 11 | 12 | 13 | 14 | 15 | 16 | 17 | 18 |
|---|---|---|---|---|---|---|---|---|---|
| SiO₂ | 33 | 25 | 30 | 43 | 31 | 60 | 54 | 50 | 38 |
| B₂O₃ | 11 | 21 | 20 | 15 | 10 | 1 | 7 | 9 | 5 |
| Al₂O₃ | 8 | 6 | | 4 | 1 | | 1 | 2 | |
| Li₂O | | | | 6 | 0,5 | | | | |
| Na₂O | | | | 3 | 0,5 | 3 | 10 | 5 | 7 |
| K₂O | | | | | | 10 | 4 | 6 | 1 |
| MgO | | 2 | | 3 | 5 | 5 | 1 | | 5 |
| CaO | | | | | | | | 1 | 9 |
| BaO | 48 | 45 | 50 | 25 | 41 | 19 | 10 | 15 | 24 |
| SrO | | | | 1 | 1 | | 3 | | |
| TiO₂ | | | | | 1 | | 9 | 12 | 7 |
| ZrO₂ | | | | | 8 | | | | 4 |
| La₂O₃ | | 1 | | | | | | | |
| Y₂O₃ | | | | | | 1 | | | |
| Yb₂O₃ | | | | | | | 1 | | |
| Gd₂O₃ | | | | | | 1 | | | |
| Ta₂O₅ | | | | | 1 | | | | |
| Summe | 100 | 100 | 100 | 100 | 100 | 100 | 100 | 100 | 100 |
| | | | | | | | | | |
| nd | 1,61 | 1,62 | 1,62 | 1,60 | 1,66 | 1,61 | 1,60 | 1,61 | 1,65 |
| vd | 59 | 58 | 60 | 60 | 51 | 59 | 47 | 44 | 45 |
| T_{g}[°C] | 643 | 640 | 636 | 493 | 639 | 554 | 531 | 580 | 569 |
| CTE_{20/300}[ppm/K] | 7,4 | 7,7 | 7,3 | 8,9 | 7,6 | 9,0 | 8,5 | 8,3 | 9,5 |
| spez. Dichte [g/cm³] | 3,5 | 3,6 | 3,6 | 3,0 | 3,8 | 2,9 | 3,3 | 2,9 | 3,3 |
| τ_{i 2mm 420nm} [%] | 99,9 | 99,8 | 99,8 | 99,9 | 99,8 | 99,9 | 99,9 | 99,5 | 99,5 |

**Tabelle 4 Schmelzbeispiele Lanthan-Borosilikate (in Gew. %)**

| Beispiel | 19 | 20 | 21 | 22 | 23 | 24 | 25 | 26 | 27 | 28 |
|---|---|---|---|---|---|---|---|---|---|---|
| SiO₂ | 12 | 19 | 33 | 10 | 20 | 13 | 9 | 25 | 31 | 24 |
| B₂O₃ | 22 | 26 | 12 | 28 | 2 | 27 | 50 | 5 | 14 | 28 |
| Al₂O₃ | 1 | | | | | 3 | | | 1 | 3 |
| Li₂O | | | | | | | | 1 | 2 | 1 |
| Na₂O | | | | | 2 | | | | | 1 |
| K₂O | 1 | 2 | | | | | | | | |
| MgO | | | | | 5 | | | 5 | 3 | |
| CaO | | | | | | 35 | 27 | 23 | 2 | 10 |
| BaO | 45 | 50 | 36 | 50 | 21 | 1 | 0,5 | 1 | 43 | 8 |
| SrO | | | | | | 10 | | 2 | | 10 |
| TiO₂ | | | | | 12 | | | 10 | 1 | |
| ZrO₂ | 2 | | 3 | | 6 | 2 | 0,5 | 3 | | 1 |
| La₂O₃ | 15 | 3 | 16 | 12 | 25 | 9 | 11 | 13 | 3 | 12 |
| Y₂O₃ | | | | | | | 2 | 1 | | |
| Yb₂O₃ | | | | | | | | 1 | | |
| Gd₂O₃ | | | | | | | | 1 | | 2 |
| Ta₂O₅ | 2 | | | | | | | 1 | | |
| Nb₂O₅ | | | | | 7 | | | 8 | | |
| Summe | 100 | 100 | 100 | 100 | 100 | 100 | 100 | 100 | 100 | 100 |
| | | | | | | | | | | |
| nd | 1,68 | 1,64 | 1,65 | 1,67 | 1,85 | 1,66 | 1,64 | 1,80 | 1,64 | 1,62 |
| vd | 55 | 60 | 56 | 57 | 32 | 57 | 54 | 35 | 55 | 60 |
| Tg[°C] | 615 | 639 | 689 | 608 | 683 | 616 | 667 | 651 | 643 | 605 |
| CTE_{20/300}[ppm/K] | 9,3 | 8,1 | 7,4 | 9,0 | 8,4 | 8,4 | 7,6 | 8,6 | 7,6 | 7,2 |
| spez. Dichte [g/cm³] | 4,1 | 3,7 | 3,8 | 4,0 | 4,4 | 3,8 | 4,2 | 3,6 | 3,6 | 3,4 |
| τ_{i 2mm 420nm} [%] | 99,6 | 99,7 | 99,8 | 99,8 | 97,9 | 99,9 | 98,2 | 99,1 | 99,8 | 99,8 |

**Tabelle 5 Schmelzbeispiele Titan-Silikate (in Gew. %)**

| Beispiel | 29 | 30 | 31 | 32 | 33 | 34 | 35 |
|---|---|---|---|---|---|---|---|
| SiO₂ | 50 | 65 | 70 | 58 | 56 | 52 | 50 |
| B₂O₃ | 10 | 1 | | | 4 | 2 | 2 |
| Al₂O₃ | 8 | | 1 | 7 | | | 0,5 |
| Li₂O | | | 1 | | | 0,5 | |
| Na₂O | | 9 | 15 | 7 | 10 | | |
| K₂O | 20 | 11 | 3 | 11 | 9 | 23 | 22 |
| TiO₂ | 10 | 11 | 7 | 14 | 20 | 22 | 25 |
| ZrO₂ | 2 | 3 | 3 | 3 | 1 | 0,5 | 0,5 |
| Summe | 100 | 100 | 100 | 100 | 100 | 100 | 100 |
| | | | | | | | |
| nd | 1,60 | 1,60 | 1,60 | 1,61 | 1,62 | 1,60 | 1,60 |
| vd | 44 | 46 | 44 | 41 | 36 | 37 | 35 |
| Tg [°C] | 447 | | | | 577 | 463 | 472 |
| CTE_{20/300} [ppm/K] | 9 | | | | 9,1 | 9,9 | 10,2 |
| spez. Dichte [g/cm³] | 3,2 | | | | 2,7 | 2,7 | 2,7 |
| t_{i 2mm 420nm} [%] | 99,9 | | | | 99,8 | 99,7 | 99,8 |

**Tabelle 6 Schmelzbeispiele Erdalkali-Titan-Silikate (in Gew. %)**

| Beispiel | 36 | 37 | 38 | 39 | 40 | 41 | 42 | 43 | 44 | 45 |
|---|---|---|---|---|---|---|---|---|---|---|
| SiO₂ | 45 | 33 | 26 | 40 | 40 | 34 | 50 | 31 | 25 | 41 |
| B₂O₃ | | 1 | 8 | 3 | 3 | | 5 | 1 | | 2 |
| Al₂O₃ | | | | 3 | | | | | 0,5 | |
| Li₂O | 2 | | | | | | | | | |
| Na₂O | 3 | 12 | 8 | 10 | 13 | 12 | 8 | 10 | 12 | 9 |
| K₂O | 10 | 6 | 5 | 7 | 8 | 6 | 5 | 6 | 1 | 8 |
| MgO | 5 | | | | | | | | | |
| CaO | | 2 | 1 | 3 | 2 | 1 | | 1 | 1 | 1 |
| BaO | 18 | 9 | 12 | 4 | 4 | 7 | 8 | 11 | 16 | 7 |
| SrO | | | | | | | 3 | | | 2 |
| ZnO | | | | | | | | | | |
| TiO₂ | 15 | 28 | 24 | 20 | 25 | 30 | 21 | 23 | 35 | 26 |
| ZrO₂ | 2 | | 8 | 5 | | | | 8 | | 3 |
| Nb₂O₅ | | 9 | | 5 | | 8 | | 4 | 4,5 | 1 |
| La₂O₃ | | | 2 | | | 2 | | | 1 | |
| Y₂O₃ | | | 2 | | 2 | | | 2 | 1 | |
| Yb₂O₃ | | | 2 | | 2 | | | | 1 | |
| Gd₂O₃ | | | 2 | | | | | 2 | 1 | |
| Ta₂O₅ | | | | | 1 | | | 1 | 1 | |
| Summe | 100 | 100 | 100 | 100 | 100 | 100 | 100 | 100 | 100 | 100 |
| | | | | | | | | | | |
| nd | 1,66 | 1,76 | 1,81 | 1,69 | 1,69 | 1,76 | 1,67 | 1,78 | 1,85 | 1,71 |
| vd | 36 | 27 | 25 | 31 | 31 | 27 | 33 | 26 | 24 | 30 |
| Tg [°C] | 619 | 570 | 589 | 552 | 524 | 566 | 434 | 591 | 630 | 578 |
| CTE_{20/300} [ppm/K] | 8,1 | 10,9 | 10,3 | 9,7 | 11,1 | 10,9 | 8,6 | 10,1 | 9,9 | 9,7 |
| spez. Dichte [g/cm³] | 3,2 | 3,2 | 3,4 | 3,1 | 2,9 | 3,1 | 4,0 | 3,3 | 3,5 | 3,0 |
| t_{i 2mm 420nm} [%] | 99,1 | 98,2 | 98,3 | 98,7 | 99,2 | 98,9 | 99,8 | 99,2 | 97,3 | 99,4 |

## Patentansprüche

1. Transparenter Schichtverbund umfassend eine leitfähige transparente Oxidschicht, eine Halbleiterschicht und eine Substratschicht, wobei die Substratschicht ein optotechnisches Hybridglas umfasst, das einen Brechungsindex nd von >1,6 aufweist, wobei das opto-technische Hybridglas einen Elastizitätsmodul von höchstens 120*10³ N/mm² aufweist und wobei das opto-technische Hybridglas Blei in Mengen von weniger als 100 ppm aufweist.

2. Transparenter Schichtverbund nach Anspruch 1, wobei das opto-technische Hybridglas ein Lanthanboratglas ist.

3. Transparenter Schichtverbund nach Anspruch 1, wobei das opto-technische Hybridglas ein Borosilikatglas ist.

4. Transparenter Schichtverbund nach Anspruch 1, wobei das opto-technische Hybridglas ein Silikatglas ist.

5. Transparenter Schichtverbund nach einem oder mehreren der vorhergehenden Ansprüche, wobei das opto-technische Hybridglas einen Brechwert von nd ≥ 1,8 hat.

6. Transparenter Schichtverbund nach einem oder mehreren der vorhergehenden Ansprüche, wobei das opto-technische Hybridglas bis auf unvermeidbare Verunreinigungen frei ist von den redox-aktiven Oxiden von Arsen und/oder Antimon.

7. Transparenter Schichtverbund nach einem oder mehreren der vorhergehenden Ansprüche, wobei die transparente Oxidschicht Indiumzinnoxid umfasst.

8. Transparenter Schichtverbund nach einem oder mehreren der vorhergehenden Ansprüche, wobei der Brechwertunterschied zwischen Oxidschicht und Substrat höchstens 0,45 beträgt.

9. Transparenter Schichtverbund nach einem oder mehreren der vorhergehenden Ansprüche, wobei die Halbleiterschicht einen organischen Halbleiter umfasst.

10. Verfahren zur Herstellung eines Schichtverbundes gemäß einem oder mehreren der Ansprüche 1 bis 9 mit den Schritten:
a. Herstellung des Substrates in einem Flachglasprozess
b. Zusammenfügen des Substrates mit anderen Schichten zu einem Schichtverbund.

11. Verfahren nach Anspruch 10, wobei der Flachglasprozess ein Floatprozess ist.

12. Verwendung eines Schichtverbundes gemäß wenigstens einem der Ansprüche 1 bis 9 zusammen mit einer Kathode in einer OLED.

13. Verwendung eines Schichtverbundes gemäß wenigstens einem der Ansprüche 1 bis 9 zusammen mit einer Kathode in einem Solarmodul.

## Claims

1. Transparent layer laminate comprising a conductive transparent oxide layer, a semiconductor layer and a substrate layer, wherein the substrate layer comprises an opto-technical hybrid glass having a refractive index nd of > 1.6, wherein the opto-technical hybrid glass has a modulus of elasticity of at most 120*10³ N/mm² and wherein the opto-technical hybrid glass comprises lead in amounts of less than 100 ppm.

2. Transparent layer laminate according to claim 1, wherein the opto-technical hybrid glass is a lanthanum borate glass.

3. Transparent layer laminate according to claim 1, wherein the opto-technical hybrid glass is a borosilicate glass.

4. Transparent layer laminate according to claim 1, wherein the opto-technical hybrid glass is a silicate glass.

5. Transparent layer laminate according to one or more of the preceding claims, wherein the opto-technical hybrid glass has a refractive index nd of ≥ 1.8.

6. Transparent layer laminate according to one or more of the preceding claims, wherein the opto-technical hybrid glass, with the exception of unavoidable impurities, is free of the redox-active oxides of arsenic and/or antimony.

7. Transparent layer laminate according to one or more of the preceding claims, wherein the transparent oxide layer comprises indium tin oxide.

8. Transparent layer laminate according to one or more of the preceding claims, wherein the difference between the refractive indexes of the oxide layer and the substrate is at most 0.45.

9. Transparent layer laminate according to one or more of the preceding claims, wherein the semiconductor layer comprises an organic semiconductor.

10. Method for the production of a layer laminate according to one or more of claims 1 to 9 comprising the steps of:
a. producing the substrate in a flat glass process
b. assembling the substrate with other layers to a layer laminate.

11. Method according to claim 10, wherein the flat glass process is a floating process.

12. Use of a layer laminate according to at least one of claims 1 to 9 together with a cathode in an OLED.

13. Use of a layer laminate according to at least one of claims 1 to 9 together with a cathode in a solar module.

## Revendications

1. Composite stratifié transparent comprenant une couche d'oxyde transparente conductrice, une couche semi-conductrice et une couche de substrat, sachant que la couche de substrat comprend un verre hybride optotechnique, qui présente un indice de réfraction nd > 1,6, sachant que le verre hybride optotechnique présente un module d'élasticité de maximum 120*10³ N/mm² et sachant que le verre hybride optotechnique présente du plomb en des quantités inférieures à 100 ppm.

2. Composite stratifié transparent selon la revendication 1, sachant que le verre hybride optotechnique est un verre de borate de lanthane.

3. Composite stratifié selon la revendication 1, sachant que le verre hybride optotechnique est un verre de borosilicate.

4. Composite stratifié transparent selon la revendication 1, sachant que le verre hybride optotechnique est un verre de silicate.

5. Composite stratifié selon l'une quelconque ou plusieurs des revendications précédentes, sachant que le verre hybride optotechnique présente un indice de réfraction nd ≥ 1,8.

6. Composite stratifié transparent selon l'une quelconque ou plusieurs des revendications précédentes, sachant que le verre hybride optotechnique, à l'exception d'impuretés inévitables, est sans oxydes à activité redox d'arsenic et/ou d'antimoine.

7. Composite stratifié transparent selon l'une quelconque ou plusieurs des revendications précédentes, sachant que la couche d'oxyde transparente comprend de l'oxyde d'étain-indium.

8. Composite stratifié transparent selon l'une quelconque ou plusieurs des revendications précédentes, sachant que la différence entre l'indice de réfraction de la couche d'oxyde et l'indice de réfraction du substrat est égale au maximum à 0,45.

9. Composite stratifié transparent selon l'une quelconque ou plusieurs des revendications précédentes, sachant que la couche semi-conductrice comprend un semi-conducteur organique.

10. Procédé servant à fabriquer un composite stratifié selon l'une quelconque ou plusieurs des revendications 1 à 9, comprenant les étapes qui suivent consistant à :
a. fabriquer le substrat lors d'un processus de transformation de verre plat ;
b. assembler le substrat et d'autres couches pour former un composite stratifié.

11. Procédé selon la revendication 10, sachant que le processus de transformation de verre plat est un processus de flottage.

12. Utilisation d'un composite stratifié selon au moins l'une quelconque des revendications 1 à 9 conjointement avec une cathode dans une OLED.

13. Utilisation d'un composite stratifié selon au moins l'une quelconque des revendications 1 à 9 conjointement avec une cathode dans un module solaire.
